(19) Europäisches Patentamt
European Patent Office
Office européen des brevets

(11) **EP 1 645 036 B1**

(12) **EUROPÄISCHE PATENTSCHRIFT**

(45) Veröffentlichungstag und Bekanntmachung des Hinweises auf die Patenterteilung:
**09.01.2019 Patentblatt 2019/02**

(21) Anmeldenummer: **04740815.8**

(22) Anmeldetag: **08.07.2004**

(51) Int Cl.:
*H03M 7/30* (2006.01)    *G06F 17/50* (2006.01)

(86) Internationale Anmeldenummer:
**PCT/EP2004/007520**

(87) Internationale Veröffentlichungsnummer:
**WO 2005/006561 (20.01.2005 Gazette 2005/03)**

(54) **DATENKOMPRESSION VON SIMULATIONSERGEBNISSEN**

DATA COMPRESSION OF SIMULATION RESULTS

COMPRESSION DE DONNEES DE RESULTATS DE SIMULATION

(84) Benannte Vertragsstaaten:
**AT BE BG CH CY CZ DE DK EE ES FI FR GB GR HU IE IT LI LU MC NL PL PT RO SE SI SK TR**

(30) Priorität: **10.07.2003 DE 10331431**

(43) Veröffentlichungstag der Anmeldung:
**12.04.2006 Patentblatt 2006/15**

(73) Patentinhaber: **Fraunhofer-Gesellschaft zur Förderung der angewandten Forschung e.V.**
**80686 München (DE)**

(72) Erfinder: **THOLE, Clemens-August**
**53229 Bonn (DE)**

(74) Vertreter: **Zimmermann, Tankred Klaus et al**
**Schoppe, Zimmermann, Stöckeler Zinkler, Schenk & Partner mbB**
**Patentanwälte**
**Radlkoferstrasse 2**
**81373 München (DE)**

(56) Entgegenhaltungen:
- AHN J-H ET AL: "Motion-compensated compression of 3D animation models" ELECTRONICS LETTERS, Bd. 37, Nr. 24, 22. November 2001 (2001-11-22), Seiten 1445-1446, XP006017574 IEE STEVENAGE, GB ISSN: 0013-5194
- TAUBIN G ET AL: "Geometric compression through topological surgery" ACM TRANSACTIONS ON GRAPHICS, ASSOCIATION FOR COMPUTING MACHINERY, NEW YORK, US, Bd. 17, Nr. 2, April 1998 (1998-04), Seiten 84-115, XP000754615 ISSN: 0730-0301
- YANG J-H ET AL: "Compression of 3-D triangle mesh sequences based on vertex-wise motion vector prediction" IEEE TRANSACTIONS ON CIRCUITS AND SYSTEMS FOR VIDEO TECHNOLOGY, Bd. 12, Nr. 12, Dezember 2002 (2002-12), Seiten 1178-1184, XP001141949 IEEE INC. NEW YORK, US ISSN: 1051-8215
- AHN J-H ET AL: "Predictive geometry compression of 3-D mesh models using a joint prediction" IEICE TRANSACTIONS ON COMMUNICATIONS, COMMUNICATIONS SOCIETY, TOKYO, JP, Bd. E85-B, Nr. 12, Dezember 2002 (2002-12), Seiten 2966-2970, XP001184756 ISSN: 0916-8516
- LENGYEL J E: "Compression of time-dependent geometry" PROCEEDINGS OF THE 1999 SYMPOSIUM ON INTERACTIVE 3D GRAPHICS. ATLANTA, GA, APRIL 26 - 28, 1999, PROCEEDINGS OF THE SYMPOSIUM ON INTERACTIVE 3D GRAPHICS, NEW YORK, NY, 26. April 1999 (1999-04-26), Seiten 89-95,226, XP001033619 ACM, US ISBN: 1-58113-082-1
- DEERING M: "Geometry compression" COMPUTER GRAPHICS PROCEEDINGS. LOS ANGELES, AUG. 6 - 11, 1995, COMPUTER GRAPHICS PROCEEDINGS (SIGGRAPH), NEW YORK, IEEE, US, 6. August 1995 (1995-08-06), Seiten 13-20, XP000546211 ISBN: 0-89791-701-4

• THOLE C-A: "Compression of LS-DYNA3D simulation results using FEMZIP" 3. LS-DYNA ANWENDERFORUM, BAMBERG 2004, 2004, Seiten E-III-1-E-III-5, XP008054952 Gefunden im Internet: URL:http://www.dynamore.de/download/af04/papers/E-III-4.pdf> [gefunden am 2005-11-08]

**Beschreibung**

Die vorliegende Erfindung bezieht sich auf die Datenkompression im allgemeinen und insbesondere auf die Komprimierung von Daten, die für einen Parameter, wie z.B. die Geschwindigkeit, für jede Gitterposition von Gitterpositionen eines unregelmäßigen Gitters einen Parameterwert umfassen, wie sie beispielsweise als Simulationsdaten in Crash-Simulationen anfallen.

Aufgrund der rasanten Entwicklung in der Computertechnologie und der damit verbundenen rasanten Steigerung der Rechenleistung hat die numerische Simulation auf vielen technischen Gebieten Einzug in die Entwicklung neuer Produkte erhalten, um das Verhalten der Produkte in bestimmten Situationen zu prognostizieren und das Ergebnis in den Design-Vorgang einzubinden. In der Geologie und Wetterkunde ist die numerische Simulation zu einem immer stabileren Werkzeug zur Erdbebenvorwarnung, Wettervorhersage oder dergleichen geworden.

Für die numerische Simulation wird die Geometrie durch eine Vielzahl von kleinen Flächen oder Körpern, sogenannten finiten Elementen, approximiert. In der Meteorologie beispielsweise sind die Gebiete rechteckig, und die Quader bilden ein reguläres Gitter. Parameterwerte, wie Temperatur, Druck, Windgeschwindigkeit und -richtung und dergleichen, werden für jede Gitterposition in dem regulären Gitter gespeichert. Aus den Parameterwerten eines Zeitschritts, wie insbesondere aus den vorhandenen Geschwindigkeiten, werden für jeden Gitterpunkt die neuen Parameterwerte zu einem neuen Zeitschritt berechnet. Diese Art der zeitlichen Fortschreibung, die im Fall der Meteorologie die Wetterentwicklung simuliert, wird als Euler-Diskretisierung bezeichnet, und unter anderem auch in der Strömungsmechanik verwendet. Die im regulären Gitter angeordneten Elementarknoten und -elemente bleiben bei ihr folglich stationär.

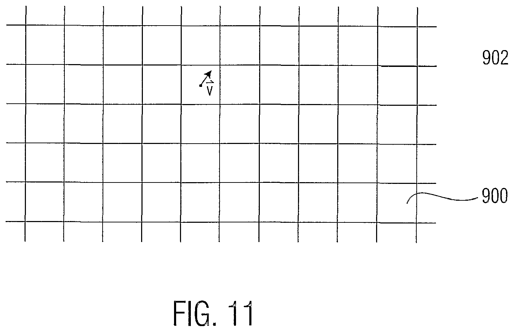

Fig. 11 zeigt exemplarisch einen Ausschnitt mehrerer Elemente 900, wie sie bei der Euler-Diskretisierung verwendet werden. Die Elemente 900 sind rechteckige Gebiete, die in Zeilen und Spalten, d.h. einem regulären Gitter, angeordnet sind. Für jedes Element 900 wird dessen augenblickliche Geschwindigkeit $\bar{v}$ gespeichert ist, wobei dies exemplarisch nur für ein Element gezeigt ist. Die Geschwindigkeit entspricht in der Meteorologie beispielsweise der Windgeschwindigkeit. Im nächsten Zeitschritt werden sich lediglich die augenblicklichen Geschwindigkeitsvektoren $\bar{v}$ für die einzelnen Elementpositionen ändern, das Gitter 902 aus den Gitterelementen 900 wird jedoch unverändert bleiben.

Ein wenig komplizierter gestaltet sich die Sachlage bei der Simulation an Objekten mit komplexerer Geometrie, wie z.B. in dem Fall von Crash-Simulationen von Automobilen. Bei solchen Simulationsanwendungen werden als finite Elemente beliebige Körper nebeneinander verwandt, um ein unregelmäßiges Gitter zu bilden, oder mehrere, die jeweils unterschiedliche Bauteile des Automobils definieren. Die Parameterwerte, wie z.B. Druck, Geschwindigkeiten und Kräfte, werden wiederum für die jeweiligen im unregelmäßigen Gitter eingeschriebenen Elemente oder die Eckpunkte, d.h. Knoten, berechnet. Anders als bei meteorologischen Simulationen werden jedoch bei Crash-Simulationen die relevanten Gitterpositionen bzw. das unregelmäßige Gitter mit dem zu simulierenden Modell mitbewegt. Diese als Lagrange-Diskretisierung bezeichnete Vorgehensweise bedeutet, dass auch die neuen Element- bzw. Knotenpositionen für jeden Zeitschritt der Simulation verwaltet bzw. gespeichert werden müssen.

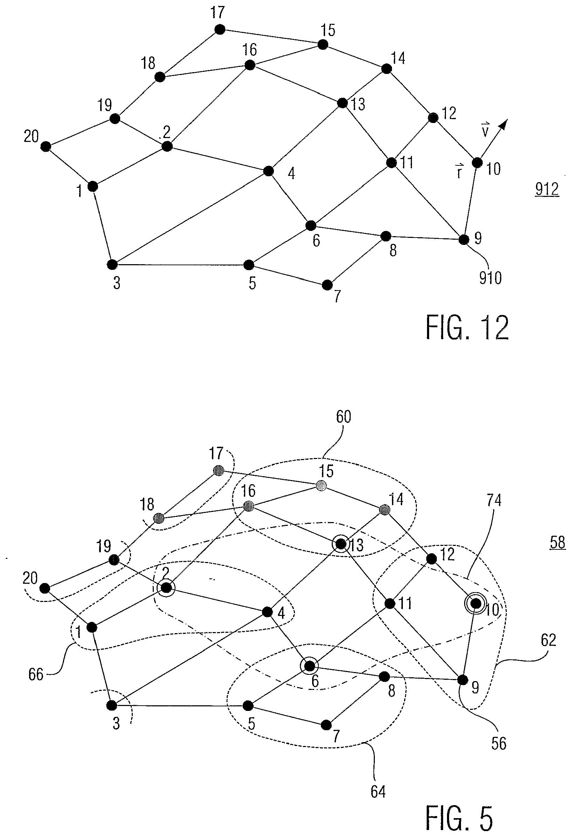

Ein Beispiel für einen Ausschnitt aus dem unregelmäßigen Gitter an einem Zeitschritt während einer Simulation nach der Lagrange-Diskretisierung ist in Fig. 12 gezeigt. Die relevanten Gitterpositionen bzw. die finiten Elemente sind hier die Gitterknoten 910 des unregelmäßigen Gitters 912. Die Gitterknoten sind nummeriert von 1 bis 20, um sie bei der Simulation eindeutig identifizieren zu können. Für jeden Knoten 910 sind, wiewohl nur für einen exemplarisch gezeigt, eine Geschwindigkeit $\bar{v}$ sowie dessen räumliche Lage $\bar{r}$ relativ zu einem gewissen Bezugspunkt (nicht gezeigt) und gegebenenfalls noch weitere Parameter gespeichert, die durch gewisse Fortschreibungsregeln für jeden nachfolgenden Zeitschritt aus den aktuellen Parameterwerten berechnet werden. Im Gegensatz zur Euler-Diskretisierung bewegen sich hier folglich die Gitterknoten bzw. das unregelmäßige Gitter während der Simulation.

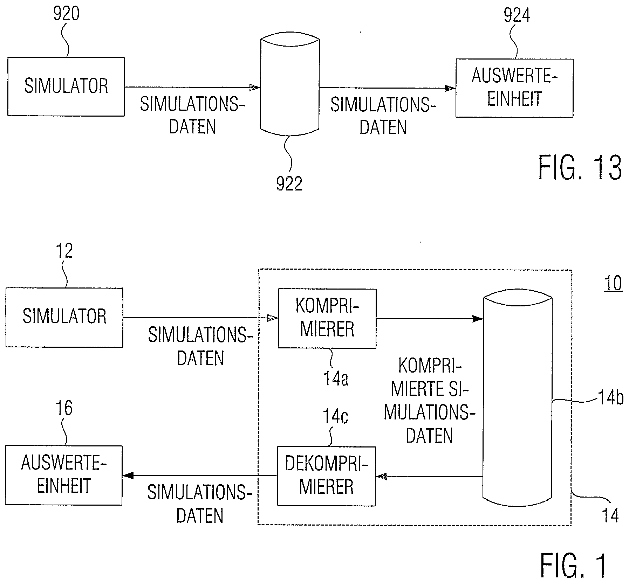

Anhand von Fig. 13 wird der grundsätzliche Aufbau einer Simulationsumgebung veranschaulicht. Ein Computer 920, hier Simulator genannt, berechnet gemäß einem bestimmten Simulationsprogramm auf der Basis von eingegebenen CAD-Daten, die das simulierende Modell beschreiben, und den Simulationsbedingungen, wie z.B. den Crash-Bedingungen, Simulationsdaten, die die Parameterwerte, d.h. in dem Fall der Lagrange-Diskretisierung die Geschwindigkeit, die Knotenpositionen und dergleichen mehr, an den Gitterpositionen des unregelmäßigen Gitters für zumindest eine Teilmenge der gerechneten Zeitschritte umfasst. Die im Zuge der numerischen Simulation erzeugten Ergebnisse enthalten nicht nur Kenngrößen. Vielmehr werden komplette Ergebnisfelder gespeichert. Im Falle zeitabhängiger Verfahren werden diese Felder zu verschiedenen Zeitschritten abgelegt.

Der Simulator 920 gibt diese Simulationsdaten an einen Speicher 922 für eine zeitlich folgende Auswertung aus. Der Speicher 922 ist typischerweise ein Massenspeicher, der eine Bibliothek von Magnetbändern aufweist, auf die zugegriffen werden kann, indem dieselben mechanisch über einen automatisierten Mechanismus von einer Ablageposition in eine Lese/Schreib-Position gebracht werden. Auf die Simulationsdaten kann dann zur Auswertung derselben durch eine Auswerteeinheit 924, die beispielsweise ebenfalls ein Computer ist, und auch aus lediglich einem anderen Anwendungsprogramm auf demselben Computer wie das Simulationsprogramm für den Simulator 920 bestehen kann, zugegriffen werden.

Ein Hauptproblem bei der Finiten-Element-Simulierung besteht in der horrenden Flut von anfallenden Simulationsdaten. So fallen in der Crash-Simulation pro Simulationslauf Ergebnisse in der Größenordnung von his zu 1-2 GByte an. Abgelegt werden zum Beispiel die Position von Gitterpunkten auf der Karosserie zu 80 Zeitschritten, um nach der Simulation mit Hilfe von Visualisierungssoftware den Verlauf des Crashs darstellen zu können. Im Zuge der Verfeinerung der numerischen Diskretisierungen werden diese Daten noch umfangreicher.

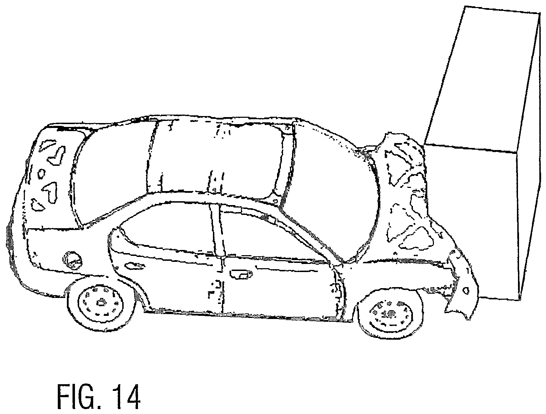

Fig. 14 zeigt als Beispiel die Abbildung eines Autos in einem Zeitschritt, der in etwa der Mitte zwischen Aufprall und Stillstand angeordnet ist, bei einem Aufprall gegen eine Wand. Das Auto wurde diskretisiert mit 286023 Knoten and 269329 Elementen. Gespeichert wurden bei der gesamten Simulation die Ergebnisse von 40 Zeitschritten. Die Steuersatzinformation, die Knotenpositionen and die Liste der aktiven Elemente benötigen 192 MB. Werden zusätzliche Ergebnisfunktionale, wie Geschwindigkeiten, Beschleunigungen, Kräfte etc., abgelegt, so umfasst das Ergebnis 761 MByte. Einzelne Crash-Simulationen erzeugen folglich große Dateien.

Hinzu kommt noch, dass Crash-Simulationen Auskunft darüber geben sollen, wie sich ein Automobil bei bestimmten Crash-Situationen verhält, ob sich beispielsweise der Bodenbereich im Fußraum des Beifahrers bei einem Crash hebt und damit das Verletzungsrisiko erhöht, oder ob er sich senkt und damit den Fußraum lediglich vergrößert. Damit der Automobil-Designer jedoch tatsächlich Rückschlüsse aus einer Simulation auf das Automobil-Design ziehen kann, muss er zunächst durch Variieren der Design-Parameter und ständige Wiederholung der Simulation mit diesen veränderten Design-Parametern überprüfen, ob die Simulation "stabil" war, d.h. ob sich das Ergebnis der Simulation in Abhängigkeit von den Design-Parametern nicht chaotisch Verhält. Das bedeutet aber, dass ein und dieselbe Simulation sehr oft für geringfügig veränderte Automobil-Design-Parameter wiederholt werden muss. Die Datenflut ist deshalb noch um ein Vielfaches höher. Die Situation ist freilich bei Simulationsdaten nach der Euler-Diskretisierung, wie z.B. in der Meteorologie, ähnlich.

Derzeit werden diese Simulationsergebnisse unkomprimiert abgelegt. Dadurch entstehen Datenbestande enormer Größe. Große Autofirmen haben die zentralgespeicherten and archivierten Simulationsdaten den 10-fachen Umfang, verglichen mitten Konstruktions- und anderen zentral abgelegten Daten.

Aufgrund der horrenden Datenflut sind die Kosten zur Speicherung der Simulationsdaten einer immer größer werdender Faktor auf dem jeweiligen auf Simulationen zurückgreifenden Gebiet, wie z.B. den Automobilzulieferern. Die Verringerung dieser Kosten durch Datenkompression stößt aber bei Simulationsdaten nach der Lagrange-Diskretisierung auf ungleich größere Probleme als bei der Datenkompression von Euler-Diskretisierung-Simulationsdaten. Wie in Fig. 11 gezeigt, sind in der Euler-Diskretisierung die finiten Elemente regelmäßig in Zeilen und Spalten angeordnet. Bei Umwandlung der Daten in einen Simulationsdatenstrom werden die Parameterwerte der einzelnen Elemente entweder zeilenweise oder spaltenweise linear nacheinander angeordnet. Die Anordnung der Elemente und ihre Einordnung in einen Simulationsdatenstrom entspricht somit im wesentlichen der von Pixeln eines Videobildes. Die Simulationsdaten für jeden einzelnen Parameter, wie z.B. eine Komponente der Geschwindigkeit, können bekannten Videokompressionsalgorithmen gleichsam wie Videoframes einer Bildaufnahme zugeführt werden und führen zu einem mehr oder minder guten Kompressionsergebnis, d.h. einer hohen Kompressionsrate. In C.E. Steffen, usw.: Weather Data Compression. Proceedings of the 19th International Conference on Interactive Information and Processing Systems (ILPS) for Meteorology, Oceonography and Hydrology, Februar 2003 und in N. Wang usw.: Experiment of a waveletbased data compression technique with precision control. Proceedings of the 19th International Conference on Interactive Information and Processing Systems (ILPS) for Meteorology, Oceonography and Hydrology, Februar 2003 ist beispielsweise für die Kompression von Wetterdaten die in der Videokomprimierung übliche Wavelettransformation vorgeschlagen worden, um die Parameterwerte in einen für die eigentliche Datenreduktion vorteilhafte Darstellung zu transformieren. In D. Saupe usw.: Compression of Weather Forecast Data. In Proceedings of the 12th International Conference on Interactive Information and Processing Systems (IIPS) for Meteorology, Oceonography und Hydrology, American Meteorological Society, Januar 1996, ist beispielsweise die Anwendung der in der Videokomprimierung beispielsweise nach dem MPEG-Videostandard übliche Vorhersage- bzw. Predictive-Codierung lineare Interpolation vorgeschlagen worden.

All diese Verfahren sind jedoch aufgrund der Unregelmäßigkeit des zugrundeliegenden Gitters nicht auf Lagrange-Diskretisierungen anwendbar. In der Crash-Simulation und ebenfalls in der Simulation einer Vielzahl anderer technischer Prozesse finden die Berechnungen auf einem sogenannten Finite-Element-Gitter statt, wie es bezugnehmend auf Fig. 12 beschrieben wurde. Die Karosserie, oder allgemein ausgedrückt das Berechnungsgebiet, wird, wie in Fig. 12 gezeigt, durch eine Vielzahl kleiner Grundkörper, wie z.B. Dreiecke, Vierecke im Raum, Tetraeder, Hexaeder oder dergleichen dargestellt, die im allgemeinen in unregelmäßiger Struktur die gesamte Karosserie abdecken. Berechnungsergebnisse liegen an den Ecken oder im Mittelpunkt der Kanten, Flächen oder Volumen der Grundkörper vor, die ein sog. numerisches Gitter bilden. Damit lassen sich Transformationen wie Wavelett-Transformationen oder Cosinustransformationen nicht anwenden.

Versuche, die Daten auf ein regelmäßiges Gitter zu übertragen, führen zu einem unverhältnismäßig hohen Aufwand und aufgrund der Interpolationen zu gegebenenfalls schlechten Komprimierungsergebnissen. Transformationen, wie die Wavelet-Transformation oder andere bei Kompression übliche Verfahren, wie z.B. die modifizierte diskrete CosinusTransformation oder dergleichen, können also aufgrund der Unregelmäßigkeit des Gitters nicht ohne zusätzlichen Aufwand, wie z.B. der Überführung der Simulationsdaten durch Interpolation an ein regelmäßiges Gitter, angewendet werden.

Standardkomprimierungsverfahren vom Huffmann-Typ, wie z.B. WINZIP®, PKZIP®, etc., erreichen keine wesentliche Reduktion des Datenvolumens. Die komprimierte Dateien haben immer noch 80% des Volumens der Ursprungsdatei.

Das Dokument von J. H. AHN et al: "Motion-compensated compression of 3D animation models", ELECTRONICS LETTERS, Band 37, Nr. 24, vom 22. November 2001, Seiten 1445-1446, beschäftigt sich mit der bewegungskompensierten Kompression von 3D-Animationsmodellen. Es schlägt vor, die Gitter der zeitlichen Abfolge in Intra-Codierte und Inter-Codierte einzuteilen. Zur Codierung der Bewegungsvektoren der intercodierten P- und B-Gitter wird das Gitter segmentiert und aus den Bewegungsvektoren eines jeden dieser Segmente ein Mittelwert-Bewegungsvektor gebildet, der dann quantisiert und codiert wird. Für jeden Bewegungsvektor wird dann lediglich noch die Differenz zu dem Stellvertreterbewegungsvektor des entsprechenden Segments weiterverarbeitet, und zwar durch eine Transformationscodierung.

Es wäre wünschenswert, ein Kompressionsverfahren zu haben, welches in der Lage ist, die große Datenflut an Simulationsdaten nach der Lagrange-Diskretisierung effektiver zu komprimieren.

Die Aufgabe der vorliegenden Erfindung besteht folglich darin, ein Komprimierungsschema zu schaffen, das eine höhere Datenkomprimierung von Parameterwerten für einen Parameter an Gitterpositionen eines unregelmäßigen Gitters ermöglicht.

Diese Aufgabe wird durch ein Verfahren nach Anspruch 1 oder 9 oder eine Vorrichtung nach Anspruch 8 oder 10 oder ein Computerprogramm nach Anspruch 11 gelöst.

Die Erkenntnis der vorliegenden Erfindung besteht darin, dass auch Daten, die für einen Parameter für jede Gitterposition von Gitterpositionen eines unregelmäßigen Gitters einen Parameterwert sowie einen gemeinsamen Bestimmungsblock aufweisen, der Nachbarschaftsinformationen umfasst, die für jede Gitterposition angeben, zu welcher oder welchen der Gitterpositionen die jeweilige Gitterposition benachbart ist, mit hoher Komprimierungsrate komprimiert werden können, wenn ihre Nachbarschaftsinformationen verwendet werden, um für den Parameterwert einer vorbestimmten Gitterposition einen Approximationswert aus dem Parameterwert zumindest einer anderen Gitterposition zu ermitteln, der zu der vorbestimmten Gitterposition benachbart ist. Eine Abbildung dieses approximierten Parameterwertes auf einen Differenzwert, aus dem in Verbindung mit dem Approximationswert auf denselben rückgeschlossen werden kann, wie z.B. die Differenz zu dem Approximationswert, und auf eine Angabe, aus der sich der Approximationswert ermitteln lässt, ergibt bei entsprechender Anwendung dieser Vorgehensweise für mehrere Gitterpositionen kleine Differenzwerte, die zur Bitdarstellung bzw. Codierung wiederum nur weniger Bits als die ursprüngliche Darstellung der Parameterwerte benötigen, sowie lediglich eine im wesentlichen nur unverkürzt darstellbare Angabe, aus der der Approximationswert ermittelbar ist.

Die Approximationswerte können entweder die Parameterwerte von Referenzgitterpositionen oder aus den Parameterwerten von Referenzgitterpositionen hergeleitete Werte sein. Dementsprechend ist für diese Referenzgitterpositionen je nach dem entweder keine weitere Codierung notwendig, da sie bereits in der Angabe enthalten ist, aus der die Approximationswerte ermitteln lässt, oder die Referenzgitterpositionen werden ebenfalls auf Differenzwerte abgebildet.

Gemäß der vorliegenden Erfindung werden die Nachbarschaftsinformationen verwendet, um die Gitterpositionen auf der Basis der Nachbarschaftsinformationen in Gruppen von zueinander benachbarten Gitterpositionen einzuteilen. Die Parameterwerte der Gitterpositionen einer Gruppe werden dann auf einen Parametersatz abgebildet, der Differenzwerte, aus denen jeweils in Verbindung mit einem aus dem Parameterwert zumindest einer Gitterposition dieser Gruppe ermittelten Approximationswert für diese Gruppe auf den jeweiligen Parameterwert der Parameterwerte der Gitterpositionen der Gruppe rückgeschlossen werden kann, sowie eine Angabe umfasst, aus der der Approximationswert ermittelbar ist. Diese Vorgehensweise vermeidet eine mühevolle Überführung der an den Gitterpositionen des unregelmäßigen Gitters definierten Parameterwerte in eine Darstellung mit einem regelmäßigen Gitter, wie es zur Anwendung herkömmlicher Videokomprimierungsverfahren notwendig wäre. Die Nutzung der ohnehin zur Verfügung stehenden Nachbarschaftsinformationen ermöglicht somit höhere Datenraten bei vertretbarem Aufwand.

Gemäß der vorliegenden Erfindung wird die räumliche Interpolation der Parameterwerte an den Gitterpositionen einer Gruppe aus dem Approximationswert hierarchisch fortgesetzt, um auch die Gruppen ihrerseits wiederum in Supergruppen einzuteilen und die Approximationswerte dieser Gruppen ihrerseits wiederum auf Parametersätze abzubilden, die interpolierte Approximationswerte und einen Superapproximationswert aufweisen. Diese Vorgehensweise kann für weitere Hierarchieebenen weiter so fortgesetzt werden.

Gemäß einem Beispiel wird die örtliche Interpolation über benachbarte Gitterpositionen kombiniert mit einer vorhergehenden oder anschließenden zeitlichen Interpolation eines Parameterwerts bzw. interpolierten Werts an einer Gitterposition aus dem Wert an einem vorangehenden und/oder nachfolgenden Zeitschritt an derselben Gitterposition.

Die Komprimierung ergibt sich dadurch, dass nur noch wenige Parameterwerte tatsächlich in ihrer ursprünglichen Bitdarstellung mit ihrer ursprünglichen Bitlänge gespeichert werden müssen, da benachbarte Parameterwerte zumeist nur geringfügig voneinander abweichen und somit der Approximationswert zumeist schon eine gute Näherung für die Parameterwerte ist. Somit entstehen viele kleine Differenzwerte, die beispielsweise die Abweichung bzw. Differenz des tatsächlichen parameterwertes zu dem Approximationswert in Inkrementen einer Quantisierung der Parameterdarstellung angeben, und für die eine Bitdarstellung mit einer kleineren Bitlänge ausreichend ist.

Bevorzugte Ausführungsbeispiele der vorliegenden Erfindung werden nachfolgend Bezug nehmend auf die beiliegenden Zeichnungen näher erläutert. Es zeigen:

Fig. 1      ein Blockschaltbild zur Veranschaulichung des grundsätzlichen Aufbaus einer Simulationsumgebung, bei der eine Datenkompression gemäß der vorliegenden Erfindung verwendet werden kann;

Fig. 2      eine schematische Zeichnung der Veranschaulichung der Simulationsdaten und ihrer Anordnung in einem Datenstrom, wie sie bei Crash-Simulationen anfallen, gemäß einem Ausführungsbeispiel der vorliegenden Erfindung;

Fig. 3      ein Flussdiagramm zur Datenkomprimierung der Simulationsdaten nach Fig. 2 gemäß einem Ausführungsbeispiel der vorliegenden Erfindung;

Fig. 4      ein Flussdiagramm zur Veranschaulichung der räumlichen Interpolation in der Datenkomprimierung nach Fig. 3 gemäß einem Ausführungsbeispiel der vorliegenden Erfindung;

Fig. 5      eine schematische Zeichnung, die einen exemplarischen Ausschnitt aus einem unregelmäßigen Gitter und die Einteilung von Gitterpositionen in Gruppen exemplarisch veranschaulicht;

Fig. 6      eine Baumstruktur zur Veranschaulichung der hierarchischen Einteilung bzw. Komprimierung nach Fig. 4;

Fig. 7      ein Flussdiagramm eines weiteren Verfahrens zur Komprimierung von Daten nach Fig. 2 gemäß einem Beispiel;

Fig. 8      eine schematische Zeichnung zur Veranschaulichung der zeitlichen Interpolation in dem Verfahren nach Fig. 7;

Fig. 8a      eine schematische Zeichnung zur Veranschaulichung der zeitlichen Interpolation nach dem Verfahren von Fig. 7 gemäß einem Beispiel;

Fig. 9      ein Flussdiagramm eines weiteren Verfahrens zur Komprimierung von Daten nach Fig. 2 gemäß einem Beispiel;

Fig. 10      ein Flussdiagramm zur Datendekomprimierung der nach Fig. 3 komprimierten Simulationsdaten gemäß einem Ausführungsbeispiel der vorliegenden Erfindung;

Fig. 11      einen Ausschnitt aus einem regelmäßigen Gitter einer Simulation nach der Euler-Diskretisierung;

Fig. 12      einen Ausschnitt aus einem unregelmäßigen Gitter nach der Lagrange-Diskretisierung;

Fig. 13      ein Blockschaltbild einer Anordnung in einer Simulationsumgebung ohne Komprimierung der Simulationsdaten; und

Fig. 14      ein Automobil in einer Crash-Simulation zu einem bestimmten Zeitschritt.

Die vorliegende Erfindung wird im folgenden lediglich exemplarisch am Beispiel von Crash-Simulationen beschrieben, obwohl die Erfindung freilich auch an anderen Simulationsdaten mit Parameterwerten an Gitterpositionen eines unregelmäßigen Gitters anwendbar ist.

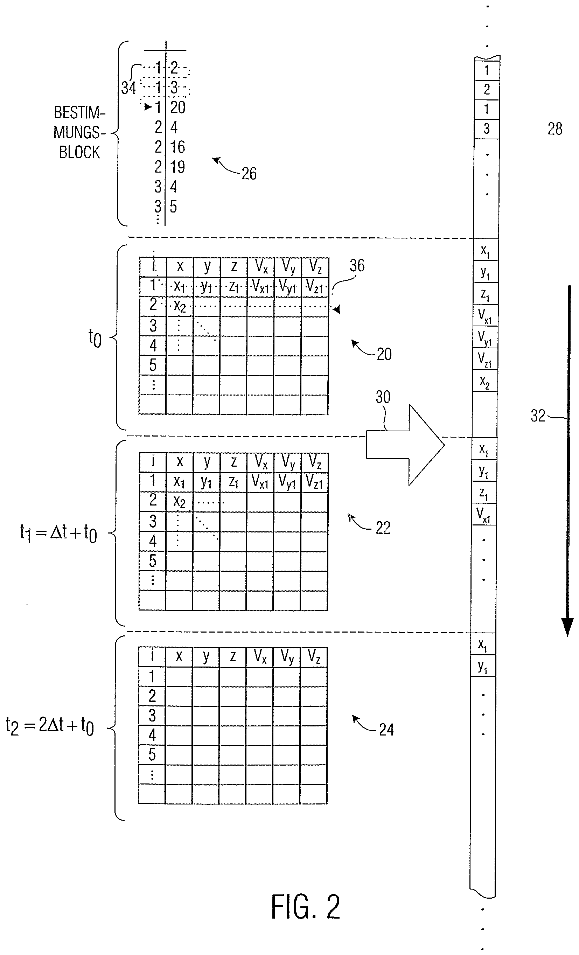

Fig. 1 zeigt eine Simulationsumgebung 10, bei der die vorliegende Erfindung implementiert sein könnte. Ein Simulator 12, der beispielsweise ein Computer und ein darauf lauffähiges Simulationsprogramm umfasst, besteht aus geeigneten Daten, wie z.B. den CAD-Modellen der Bauteile eines Automobils, und geeigneten Crash-Bedingungen, wie z.B. der Geschwindigkeit mit der ein Automobil auf ein Hindernis trifft und der Form und Lage des Hindernisses selbst, sowie Simulationsdaten, die den simulierten Crash in aufeinanderfolgenden Zeitschritten beschreiben, iterativ aus dem jeweils vorhergehenden Zeitschritt unter Berücksichtigung physikalischer Erhaltungssätze erhalten wurden und zur Bildschirmdarstellung des Crash-Verlaufes oder für weitere Auswertungen notwendig sind. Die Simulationsdaten werden später Bezug nehmend auf Fig. 2 genauer beschrieben.

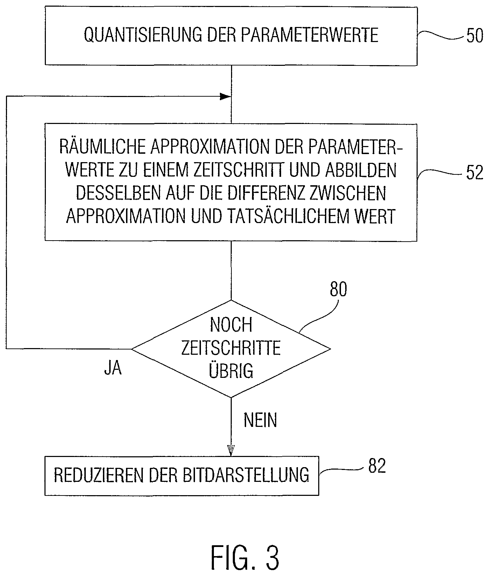

Die Simulationsdaten gibt der Simulator 12 an eine Datenverwaltungseinheit 14 aus. Die Datenverwaltungseinheit 14 umfasst einen Komprimierer 14a, einen Speicher 14b und einen Dekomprimierer 14c. Ein Eingang des Komprimierers 14a ist mit dem Ausgang des Simulators 12 verbunden, um die Simulationsdaten zu erhalten, zu komprimieren und an einem Ausgang desselben die komprimierten Simulationsdaten auszugeben. Die Funktionsweise des Komprimierers 14a wird später Bezug nehmend auf Fig. 3-9 in Bezug auf verschiedene Ausführungsbeispiele beschrieben.

Die komprimierten Simulationsdaten 14a werden in dem Speicher 14b dauerhaft gespeichert und stehen von da an Zugriffen zur Auswertung derselben zur Verfügung. Der Dekomprimierer 14c ist an seinem Eingang mit dem Speicher 14b verbunden, um bei Abruf der komprimierten Simulationsdaten dieselben von dem Speicher zu erhalten, zu dekomprimieren und an seinem Ausgang wieder die ursprünglichen Simulationsdaten auszugeben, die je nach Komprimierung, wie sie im folgenden ja noch beschrieben wird, relativ zu den Ursprungsdaten im wesentlichen nicht verlustbehaftet sind, abgesehen von beispielsweise Rundungsfehlern etc.

Eine Auswerteeinheit 16 ist mit dem Ausgang des Dekomprimierers 14c verbunden, um die abgerufenen Simulationsdaten aus dem Speicher 14b zu erhalten und geeignet auszuwerten, wie z.B. die Simulationsdaten verschiedener Simulationen miteinander zu verknüpfen, um Rückschlüsse auf die Stabilität der Simulation und damit ihrer Aussagekraft zuzulassen.

Der Aufbau der Simulationsdaten und insbesondere der Datenstrom von Simulationsdaten bei Eintreffen an den Komprimierer 14a ist in Fig. 2 exemplarisch dargestellt. Der Simulator 12 berechnet für ein unregelmäßiges Gitter, wie es beispielsweise bei 912 in Fig. 12 gezeigt ist, und das beispielsweise ein Bauteil eines Automobils bei einer Crash-Simulation darstellt, für unterschiedliche Parameter die Parameterwerte an den Gitterpunkten bzw. Knoten 910 an einem Zeitschritt aus den Parameterwerten dieser Parameter zu einem vorhergehenden Zeitschritt. Die Parameterwerte zu einem Zeitschritt $t_0$ sind in Fig. 2 beispielsweise in einer Tabelle 20 gezeigt. Die Parameter umfassen bei dem vorliegenden Ausführungsbeispiel exemplarisch die Positionskoordinaten $x_i$, $y_i$ und $z_i$ des Orts $\bar{r}_i$ des jeweiligen Knotens i sowie die Geschwindigkeitskomponenten $v_{xi}$, $v_{yi}$ und $v_{zi}$ der Geschwindigkeit $\bar{v}_i$ des jeweiligen Knotens i. Die Tabelle 20 umfasst somit so viele Zeilen wie Knotenpunkte des unregelmäßigen Gitters 912 vorhanden sind, und sechs Spalten, nämlich für die drei Ortskoordinaten und die drei Geschwindigkeitskomponenten. Die Tabelle von Parameterwerten zu einem darauffolgenden Zeitschritt $t_1$ ist in Fig. 2 bei 22 angezeigt. Sie enthält für jeden Gitterknoten 910 die gleichen Informationen bzw. die Parameterwerte für die jeweiligen sechs Parameter, hergeleitet durch entsprechende, die physikalischen Erhaltungssätze berücksichtigenden Regeln aus den Parameterwerten der Tabelle 20. In äquidistanten Zeitintervallen $\Delta t$ werden somit Tabellen von Parameterwerten für die Knoten zu unterschiedlichen Zeitpunkten erhalten. Eine Tabelle zum Zeitpunkt $t_2$ zwei Zeitschritte $\Delta t$ nach dem Zeitpunkt $t_0$ ist beispielsweise bei 24 gezeigt.

Die jeweiligen Knoten des Simulationsmodells - in Fig. 11 sind exemplarisch lediglich 20 gezeigt - können als eine Punktwolke betrachtet werden, deren Punkte die Knoten des unregelmäßigen Gitters sind, und zwischen deren Punkten gemäß dem unregelmäßigen Gitter Nachbarschaftsbeziehungen bestehen. Die Nachbarschaftsbeziehungen sind in Fig. 11 durch die Verbindungslinien zwischen den Knotenpunkten zeichnerisch dargestellt. So sind beispielsweise die Knoten 1 und 2, 1 und 3, 1 und 20, 2 und 4 usw. jeweils paarweise zueinander benachbart. Die Nachbarschaftsbeziehung der Gitterpunkte bzw. Knoten dient bei der Simulation dazu, zu bestimmen, welche Knoten aufeinander Kräfte ausüben und welche nicht, wobei nicht benachbarte Knoten als voneinander unabhängig betrachtet werden. Die Nachbarschaftsbeziehungen sind in einem sogenannten Bestimmungsblock 26 definiert. Der Bestimmungsblock 26 umfasst hierzu beispielsweise wie in Fig. 2 gezeigt eine Tabelle mit zwei Spalten, in deren Zeilen jeweils Paare von Knotennummern Nachbarschaftspaare angeben. Fig. 2 zeigt exemplarisch acht benachbarte Paare von Punkten aus dem Ausschnitt des unregelmäßigen Gitters von Fig. 11, nämlich die Paare (1, 2), (1, 3), (1, 20) usw. Der Bestimmungsblock 26 kann freilich auch noch weitere Informationen umfassen, die für denjenigen, der die Simulationsdaten erhält, d.h. die Auswerteeinheit 16, wichtig sind, um die Simulationsdaten syntaktisch zu analysieren, z.B. die Angabe des Zeitinkrements $\Delta t$ zwischen aufeinanderfolgenden Zeitschritten $t_0$, $t_1$ und $t_2$, die Anzahl der Parameter pro Knotenpunkt und die Bedeutung derselben sowie die Anzahl der Knotenpunkte, der Anzahl an Bauteilen usw.

In Fig. 2 ist auf der rechten Seite der Figur exemplarisch ein Datenstrom 28 gezeigt, in welchen die Daten 22-26 durch den Simulator 12 vor ihrer Ausgabe überführt werden, wobei die Überführung mit einem Pfeil 30 angedeutet ist. Die Überführung in den Datenstrom 28 besteht im wesentlichen in einer linearen Anordnung der ansonsten in zweidimensionalen Tabellen angeordneten Daten 20-26 entlang einer Datenstromrichtung 32. Der in Fig. 2 exemplarisch gezeigte Simulationsdatenstrom 28 beginnt mit dem Bestimmungsblock 26, in der die Knotennummern, wie durch einen gepunkteten Pfeil 34 angedeutet, beispielsweise zeilenweise durchlaufen werden, um in Datenstromrichtung 32 die Knotennummern von benachbarten Knoten unmittelbar aufeinanderfolgend anzuordnen. Auf den Bestimmungsblock 26 folgt im Datenstrom 28 in Datenstromrichtung 32 folgend ein Abschnitt von Daten, der die Parameterwerte an dem Knoten i zum Zeitpunkt $t_0$ enthält, wobei hier exemplarisch zunächst die sechs Parameterwerte für den Knoten 1, dann die sechs Parameterwerte für den Knoten 2 usw. abgelegt werden, d.h. die Tabelle 20 zeilenweise durchlaufen wird, wie es durch einen gepunkteten Pfeil 36 angedeutet ist. Hieran schließen sich entsprechend die Daten der folgenden

Zeitschritte $t_1$, $t_2$ usw. an.

Fig. 2 zeigt freilich nur ein exemplarisches Beispiel einer Crash-Simulationsdatei, und dieselbe könnte alternativ auch die Parameterwerte von lediglich ausgewählten aller der Simulation zugrundeliegenden Zeitschritte aufweisen. Die ausgewählten Zeitschritte müssten entgegen vorliegendem Ausführungsbeispiel auch nicht äquidistant zueinander angeordnet sein, sondern könnten dort enger liegen, wo die Verformung des Crash-Autos die größte Dynamik aufweist.

Die folgenden Ausführungsbeispiele für die Komprimierung der Daten von Fig. 2 machen nun von den im Bestimmungsblock enthaltenen Nachbarschaftsbeziehungen Gebrauch, um eine besonders effektive Komprimierung der Simulationsdaten zu erzielen. Insbesondere wird unter Ausnutzung der Nachbarschaftsbeziehungen ein Parameterwert an einem Knoten aus dem Parameterwert oder den Parameterwerten eines oder mehrerer benachbarter Knoten approximiert und lediglich die Differenz in den komprimierten Datenstrom übernommen bzw. gespeichert. Da zumeist der Parameterwert an einem Knoten nur geringfügig von dem Parameterwert an einem Nachbarknoten abweicht, entstehen hierdurch nur geringe Abweichungen zur Approximation und die sich ergebenden Differenzen können mit weniger Bits codiert werden.

Ein Ausführungsbeispiel für eine Komprimierung der Simulationsdaten von Fig. 2 ist in Fig. 3 gezeigt. Die Schritte in Fig. 3 werden durch den Komprimierer 14a in Fig. 2 durchgeführt, der beispielsweise ein auf einem Computer lauffähiges Programm ist, das Routinen aufweist, die bei Durchführung des Programms durch den Computer die Schritte von Fig. 3 durchführen.

Zunächst werden in einem Schritt 50 die Parameterwerte quantisiert bzw. quantifiziert. Die Parameterwerte liegen beispielsweise ursprünglich in einer 32-Bit-Darstellung vor. Durch den Schritt 50 wird die Genauigkeit der Parameterwerte auf eine vorgegebene untere Schranke reduziert. Da diese Schranke abhängig vom Zahlenbereich sein kann, ist unter Umständen eine Transformation der einzelnen Werte z.B. mit einer logarithmischen Funktion erforderlich. Der Schritt 50 kann somit entweder das Überführen eines Parameterwerts auf einen Parameterwert mit einer Bitdarstellung kleinerer Bitlänge oder das Überführen eines Parameterwerts in einen quantisierten Parameterwert aufweisen, der in Inkrementen eine Anzahl von Quantisierungsschritten bis hin zum ursprünglichen Parameterwert angibt, auf dessen Bitdarstellung eine geringere Bitlänge als die des ursprünglichen Parameterwerts aufweist, und der nach Rücktransformation einen dem ursprünglichen Parameterwert mehr oder weniger ähnlichen Wert bzw. einen mehr oder weniger verlustbehafteten Wert ergibt. Die Transformation ist kann fest sein, so dass sie beim Dekomprimierer 14c bekannt ist und nicht übermittelt werden muss bzw. in den komprimierten Datenstrom eingebunden zu werden braucht. Alternativ erfolgt in den komprimierten Daten ein Hinweis durch einen Index auf eine von vordefinierten Transformationen oder der Schritt 50 umfasst das Einfügen einer Transformationstabelle in die komprimierten Daten, so dass der Dekomprimierer die Quantisierungsschrittweiten rekonstruieren kann. In der folgenden Beschreibung ist der Vereinfachung halber weiterhin von "den Parameterwerten" die Rede, obwohl dieselben in Schritt 50 tatsächlich bereits auf verlustbehaftete Quantisierungswerte abgebildet wurden.

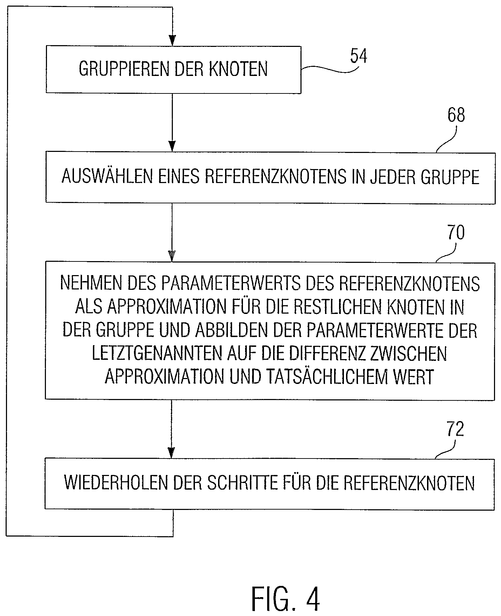

Danach folgt in einem Schritt 52 eine räumliche Approximation der in Schritt 50 quantisierten Parameterwerte zu einem Zeitschritt und Abbilden derselben auf die Differenz zwischen Approximation und tatsächlichem Wert. Der genaue Ablauf der Approximation von Schritt 52 ist in Fig. 4 dargestellt. In einem Schritt 54 werden zunächst die Gitterknoten in Gruppen eingeteilt. Die Gruppeneinteilung ist derart, dass jeder Knoten nur einer Gruppe zugeteilt wird bzw. angehört. Der Schritt 54 wird auf der Basis der Nachbarschaftsinformationen durchgeführt, die in dem Bestimmungsblock 26 (Fig. 2) enthalten sind. Die Gruppierung wird ferner derart durchgeführt, dass die Knoten jeder Gruppe zueinander benachbart sind. Mehrere Knoten zählen gemäß der vorliegenden Erfindung als zueinander benachbart, wenn jeder Knoten aus der Gruppe zumindest zu einem anderen Knoten aus der Gruppe benachbart ist, und vorzugsweise, wenn zwischen zumindest ein Knoten in der Gruppe zu zwei anderen aus der Gruppe benachbart ist. Die Gruppen sollten sich auch nicht über zu viele Nachbarschaftspaare, d.h. den Verbindungslinien in Fig. 12, erstrecken. Beispielsweise könnte festgelegt sein, dass die Einteilung derart zu treffen ist, dass zwischen zwei Knoten einer Gruppe die kleinste Anzahl an Nachbarschaftspaaren, die von dem einen zu dem anderen führt, nie größe als ein bestimmter Wert ist, wie z.B. größer als zwei. Jede Gruppe bestehe auch beispielsweise nur aus einer maximalen Anzahl von Knoten, wie z..B. vier. Zur Gruppeneinteilung könnte beispielsweise ein Greedy-Algorithmus verwendet werden.

Zur Veranschaulichung des Schritts 54 zeigt Fig. 5 denselben Ausschnitt eines unregelmäßigen Gitters wie Fig. 12. Die Knoten, hier mit dem Bezugszeichen 56 versehen, des unregelmäßigen Gitters 58, die wiederum von 1 bis 20 nummeriert sind, werden in dem Schritt 54 exemplarisch wie durch die gestrichelten Linien angedeutet zu Dreier- und Vierer-Gruppen zusammengefasst, wobei in Fig. 5 Gruppen 60, 62, 64 und 66 vollständig zu ersehen sind und die Knoten 13-16, 9-12, 5-8 bzw. 1, 2 und 4 umfassen. Die Gruppen 60-66 erfüllen alle oben genannten Bedingungen. Die Gruppe 64 beispielsweise weist nur Knoten 5-8 auf, die zueinander benachbart sind. Die Knotenanzahl beträgt nicht mehr als vier. Keine Kette von benachbarten Knotenpaaren mit minimaler Anzahl an Knotenpaaren, die von einem Knoten zu einem anderen der Knoten führt, umfasst mehr als zwei Knotenpaare, wie z.B. die Knoten 5 und 8 durch die Knotenpaare ((5, 6) und (6, 8) oder (5, 7) und (7, 8).

In einem Schritt 68 wird dann in jeder Gruppe 60-66 aus den in der jeweiligen Gruppe enthaltenen Knoten 56 ein Referenzknoten ausgewählt, wobei das in Fig. 5 exemplarisch die Knoten 56 mit den Nummern 13, 10, 6 und 2 sind.

Die Auswahl kann zufällig oder nach bestimmten Kriterien deterministisch erfolgen, wie z.B. die bevorzugte Auswahl des Knotens mit den meisten Nachbarknoten, wie es bei der Gruppe 66 der Fall ist.

In einem Schritt 70 wird daraufhin der in Schritt 50 bereits quantisierte Parameterwert des jeweiligen Referenzknotens als Approximation für die restlichen Knoten der jeweiligen Gruppe verwendet, wobei die Parameterwerte der Letztgenannten auf die Differenz zwischen Approximation und tatsächlichem Wert abgebildet werden. Dies werde beispielsweise an der Gruppe 60 mit den Knoten 14-16 veranschaulicht. Als Referenzknoten ist der Knoten 13 ausgewählt. Ihm sind die Parameterwerte $x_{13}$, $y_{13}$, $z_{13}$, $v_{x_{13}}$, $v_{y_{13}}$ und $v_{z_{13}}$ zugeordnet. Die Parameterwerte der übrigen Knoten 14-16 werden wie folgt auf Differenzwerte zu den Parameterwerten abgebildet, nämlich $x_j$ auf $x_j-x_{13}$, $y_j$ auf $y_j-y_{13}$, $z_j$ auf $z_j-z_{13}$, $v_{x_j}$ auf $v_{x_j}-v_{x_{13}}$, $v_{y_j}$ auf $v_{y_j} - v_{y_{13}}$ und $v_{z_j}$ auf $v_{z_j} - v_{z_{13}}$, mit $j$ = 14, 15 oder 16. Die Differenzwerte werden recht klein sein, da die Ortsabweichung der Knotenpunkte 14-16 sowie die Geschwindigkeit derselben nur geringfügig vom Ort bzw. Geschwindigkeit des Referenzknotens 13 abweichen wird. Somit ergeben sich kleine Differenzwerte für die Knoten 14-16, die mit geringerer Bitlänge codiert oder besser in Huffman-Codewörter umgewandelt werden können als die ursprünglichen Parameterwerte, wodurch eine hohe Komprimierungsrate erzielt werden kann.

Bei dem Schritt 70, wie er im vorhergehenden beschrieben worden ist, werden folglich die Parameterwerte der Knoten einer Gruppe auf einen Parametersatz abgebildet, bei dem die Parameterwerte aller Knoten bis auf den des Referenzknotens auf die Differenzwerte zu dem Parameterwert des Referenzknotens abgebildet sind, während der Parameterwert des Referenzknotens für die Dekomprimierung identisch abgebildet wird, d.h. vorerst unverändert bleibt, bis er, wie es im folgenden erläutert werden wird, iterativ einer weiteren räumlichen Interpolationsstufe höherer Hierarchieebene zugeführt wird. Für die Gruppe 60 würden die parameterwerte folglich auf folgenden Parametersatz abgebildet werden: $\{x_{14}-x_{13}, y_{14}-y_{13}, z_{14}-z_{13}, v_{x_{14}}-v_{x_{13}}, v_{y_{14}}-v_{y_{13}}, v_{zv14}- v_{z_{13}}, x_{15}-x_{13}, y_{15}-y_{13}, ..., v_{y_{15}}-v_{y_{13}}, v_{z15}-v_{z_{13}}, x_{13}, y_{13}, z_{13}, v_{x_{13}}, v_{y_{13}}, v_{z_{13}}\}$, wobei die Reihenfolge der Elemente des Parametersatzes nicht erheblich ist sondern lediglich auf Dekomprimiererseite bekannt sein muss und die Angabe des Referenzparameterwerts für die Parameter, wie oben angedeutet, auch ihrerseits wiederum anders aussehen kann. Jeder Parametersatz kann wiederum einen Header aufweisen, um für den Dekomprimierer erkennbar zu machen, wie die in dem Parametersatz enthaltenen Daten zu parsen bzw. syntaktisch zu analysieren sind, und insbesondere anzugeben, welcher Knoten der Referenzknoten ist.

Als Alternative zum Schritt 70 ist es ferner möglich, aus den Knoten jeder Gruppe einen Mittelwert zu bestimmen und diesen als Approximation für die Parameterwerte aller Knoten in der Gruppe zu verwenden. In diesem Fall würden die Parameterwerte der Knoten einer Gruppe folglich auf einen Parametersatz abgebildet werden, der die Differenzwerte zum Mittelwert für jeden Knoten plus einer Angabe, aus der sich der Mittelwert zur Decodierung bestimmen lässt, enthält. Der erhöhte Aufwand zur Berechnung des Mittelwerts verglichen zur vorhergehenden beschriebenen Approximation anhand des Parameterwerts eines Referenzknotens wird durch eine bessere Approximation bzw. kleinere Differenzwerte ausgeglichen, die folglich eine erhöhte anschließende Datenreduktion ermöglichen. Wiederum am Beispiel der Gruppe 60 würde folglich die Gruppe von Parameterwerten $x_{13}$, $x_{14}$, $x_{15}$ und $x_{16}$ auf einen Parametersatz bzw. Datenblock $\{x_{13}-\bar{x}, x_{14}-\bar{x}, x_{15}-\bar{x}, x_{16}-\bar{x}, \bar{x}\}$, mit $\bar{x}$ = ¼($x_{13} + x_{14} + x_{15} + x_{16}$) abgebildet werden, mit ähnlichem Vorgehen für jeden anderen Parameter $y$, $z$, $v_x$, $v_y$ und $V_z$.

In einem Schritt 72 werden daraufhin die Schritte 54-70 iterativ für die Referenzknoten wiederholt, wenn mehrere Referenzknoten vorhanden sind, was als nächste Hierarchiestufe bei der Kompression bezeichnet wird. Anders ausgedrückt werden die Schritte 54-70 für die in 54 gebildeten Gruppen mit ihrem jeweiligen Approximationswert wiederholt. Eine Gruppe ist dann benachbart im Sinne von Schritt 54, wenn zumindest ein Knoten aus einer Gruppe mit einem Knoten aus der anderen Gruppe benachbart ist. Hieraus ergibt sich quasi ein neues Gitter. In Fig. 5 ist exemplarisch mit einer Strichpunktlinie 74 die Zusammenfassung der Gruppen 60-66 zu einer Gruppe einer höheren Hierarchieebene dargestellt, unter denen wiederum der Referenzknoten 10 der Gruppe 62 als Referenzknoten für die Gruppe 74 ausgewählt ist.

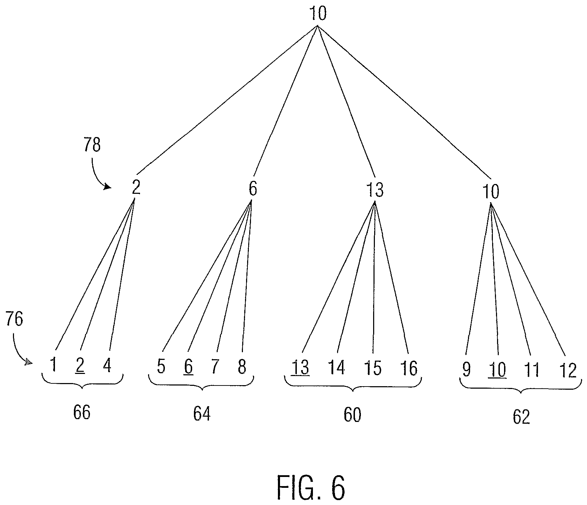

Fig. 6 zeigt den hierarchischen Aufbau der Daten, wie er sich nach Fig. 4 ergibt. Fig. 6 zeigt eine Baumdarstellung, wobei die Zahlen in Fig. 6 den Knotennummern von Fig. 5 entsprechen. Unterstrichene Zahlen bedeuten die jeweiligen Referenzknoten. Fig. 6 zeigt deutlich die hierarchische Einteilung der Knoten in Fig. 5. In einer untersten Hierarchieebene 76, wie sie beim ersten Durchgang der Schritte 54, 68, 70 erzeugt wird, sind jeweils die einzelnen Knoten 56 zu Gruppen 60-66 zusammengefasst. Diese Gruppen 60-66 werden in der weiteren Hierarchieebene 78 zu einer weiteren Supergruppe zusammengefasst. Jede Gruppe der Supergruppe wird durch ihren Approximationswert repräsentiert, also nach dem vorhergehenden beiden alternativen Ausführungsbeispielen entweder durch den Parameterwert des Referenzknotens oder durch den Mittelwert der jeweiligen Gruppe. Anstatt nun die in den Schritten 50, 68 und 70 entstandenen Approximationswerte für jede Gruppe einer Hierarchieebene einfach in die komprimierte Fassung der Daten zu übernehmen, werden die Approximationswerte in der nächsten Hierarchieebene auf Differenzwerte zu einem weiteren Approximationswert der nächsthöheren Hierarchieebene zusammengefasst, quasi einem Superapproximationswert.

Wie es durch Unterstreichen der 10 in Fig. 6 dargestellt ist, werden beispielsweise die Parameterwerte der Knoten 2, 6 und 13, d.h. die Referenzparameterwerte, durch ihre Differenzwerte zu dem Positionswert des Knotens 10 ersetzt, bzw. auf einen Parametersatz abgebildet, der diese Differenzwerte und den Parameterwert des Knotens 10 enthält.

Gemäß dem alternativen Ausführungsbeispiel könnten die Mittelwerte der Gruppen 66, 64, 60 und 62 durch ihre Differenzwerte zu dem Mittelwert aus allen vier Mittelwerten ersetzt werden. Bei dem kleinen Gitterausschnitt nach Fig. 5 existierte also lediglich nur noch ein großer Wert, während die anderen Werte lediglich kleine Abweichungen zur Approximation der jeweiligen Hierarchieebene darstellten.

Zurückkehrend zu Fig. 3, wird der Schritt 52 für jeden Zeitschritt wiederholt, bei dem noch keine räumliche Approximation durchgeführt wird (Schritt 80). Danach werden in einem Schritt 82 die entstehenden Daten in ihrer Bitdarstellung reduziert. Das kann, wie bereits im vorhergehenden erwähnt, dadurch geschehen, dass die Differenzwerte, die durch Differenz zur Approximation erhalten wurden, in einer Bitdarstellung mit geringerer Bitlänge dargestellt werden, oder dass die entstehenden Werte einer Huffman-Codierung unterzogen werden. Ein spezielles Ausführungsbeispiel sieht vor, dass unter den in einer Hierarchieebene erzeugten Differenzwerten der niedrigste Wert global gespeichert wird, während für die anderen nur die Anzahl an Inkrementen im Sinne der Quantifizierung von Schritt 50 gespeichert wird, um die dieselben gegenüber dem niedrigsten Wert erhöht sind, so dass wenige Bits für die Codierung der Differenzwerte bzw. räumlich interpolierten Werte ausreichen.

Gemäß den vorhergehenden Ausführungsbeispielen ist lediglich eine räumliche Interpolation zur Datenreduktion verwendet worden, die hierarchisch bis zu einer beliebigen Hierarchiestufe fortgesetzt werden könnte, bis schließlich und endlich lediglich ein Parameterwert bzw. ein Approximationswert in voller Höhe abzuspeichern wäre (in Fig. 6 wäre dies die Wurzel des Baumes, der des Knotens 10, wenn die Knoten 1-20 die einzigen wären).

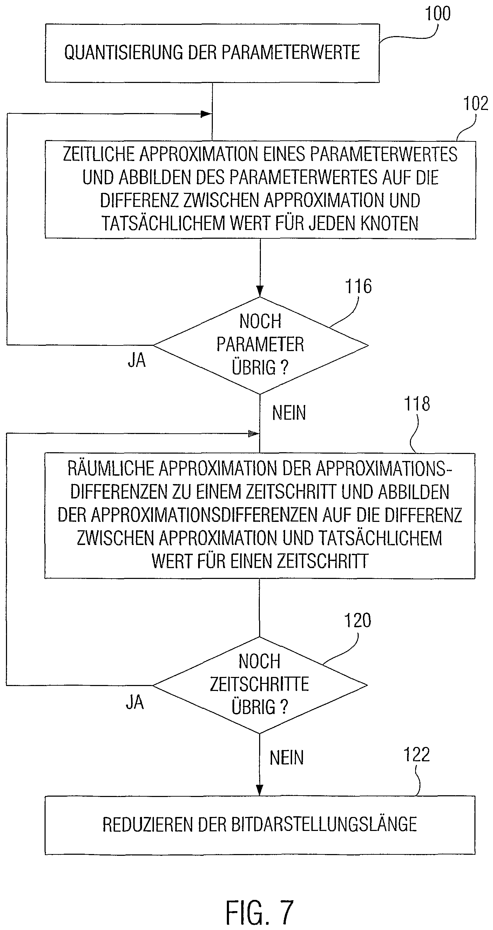

Gemäß dem nachfolgenden Beispiel von Fig. 7-8a wird die räumliche Interpolation mit einer zeitlichen Interpolation verknüpft. In einem Schritt 100 werden zunächst wieder die Parameterwerte in dem Simulationsdatenstrom 28 quantisiert bzw. quantifiziert, wie es auch in Schritt 50 von Fig. 3 der Fall war.

In einem Schritt 102 werden daraufhin die Parameterwerte bzw. quantifizierten Parameterwerte zu einem vorbestimmten Zeitschritt zeitlich approximiert und die Parameterwerte dieses Zeitschrittes auf die Differenz zwischen Approximation und tatsächlichem Wert abgebildet.

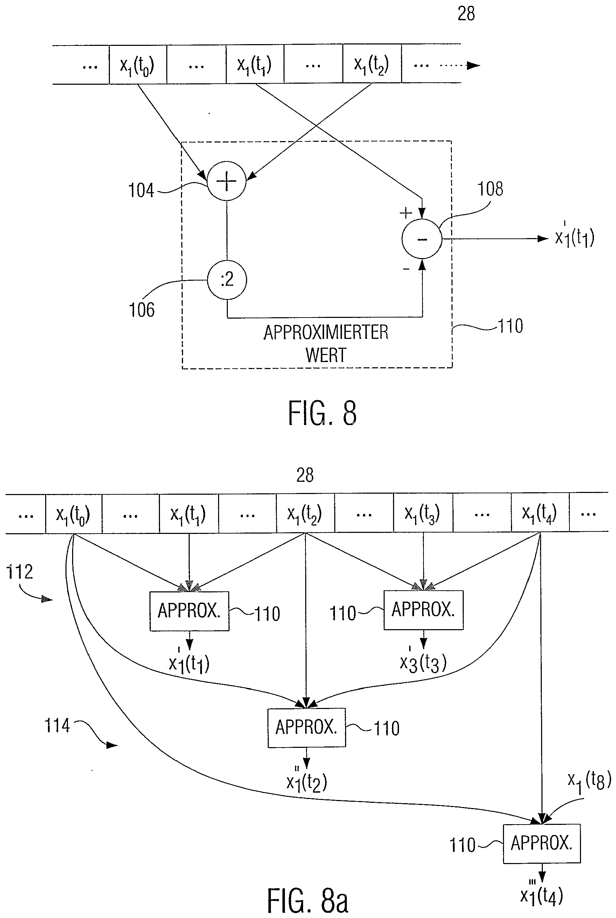

Die zeitliche Approximation 102 ist in Fig. 8 schematisch veranschaulicht. Gezeigt ist in Fig. 8 der Datenstrom 28, wobei innerhalb desselben der Parameterwert $x_1$, also die x-Koordinate des Knoten 1, für drei aufeinanderfolgende Zeitschritte $t_0$, $t_1$ und $t_2$ hervorgehoben sind, angezeigt durch $x_1(t_0)$, $x_1(t_1)$ und $x_1(t_2)$. Wie es zu erkennen ist, wird der Parameterwert $x_1(t_1)$ für den Zeitschritt $t_1$ aus den Parameterwerten für diesen Knoten zum vorhergehenden und nachfolgenden Zeitschritt $t_0$ bzw. $t_2$ approximiert, indem aus den Letztgenannten die Summe 104 gebildet wird, und die Summe wiederum halbiert 106 wird. Der sich ergebende Approximationswert ist folglich der Mittelwert aus dem Parameterwert des vorhergehenden und nachfolgenden Zeitschritts. Der Approximationswert wird von dem tatsächlichen Wert des Parameterwerts zum interessierenden Zeitschritt $t_1$ abgezogen 108, wobei das Ergebnis der Differenz vergleichsweise klein zu dem Parameterwert $x_1$ zum Zeitschritt $t_1$ sein wird, da anzunehmen ist, dass sich der Wert eines Parameters in aufeinanderfolgenden Zeitschritten nur moderat ändert. Insbesondere gilt also für den Differenzwert $x'_1(t_1)$, auf dem der tatsächliche Parameterwert $x_1(t_1)$ zum Zeitschritt $t_1$ abgebildet wird:

$$x'_1(t_1) = x_1(t_1) - \frac{x_1(t_0) + x_1(t_2)}{2}$$

Diese Vorgehensweise trägt dem Umstand Rechnung, dass sich die Parameterwerte über die aufeinanderfolgenden Zeitschritte in der Regel nur allmählich ändern, so dass eine lineare Interpolation der Werte aus dem unmittelbar folgenden und dem unmittelbar vorhergehenden Parameterwert eine sehr gute Näherung für den augenblicklichen bzw. interessierenden Parameterwert ist.

Fig. 8 zeigt lediglich eine Approximation 110, die durch die additive Verknüpfung des Parameterwerts zu einem vorhergehenden Zeitschritt und eines Parameterwerts zu einem nachfolgenden Zeitschritt, Halbierung der Summe und Abzug des Ergebnisses von dem tatsächlichen, zu approximierenden Wert gekennzeichnet ist.

Durch Wiederholung der Approximation 110 von Fig. 8 kann der Parameter $x_1$ für die Hälfte aller Zeitschritte auf einen niedrigwertigen Differenzwert abgebildet werden. Dies ist in Fig. 8a gezeigt. In dem Datenstrom 28 sind die Parameterwerte $x_1(t_0)$, ..., $x_1(t_4)$ des Parameters x für den Knoten 1 zu fünf aufeinanderfolgenden Zeitschritten $t_0$-$t_4$ hervorgehoben. Der Parameterwert zum Zeitschritt $t_1$ wird aus den Parameterwerten der Zeitschritte $t_0$ und $t_2$ zu $x'_1(t_1)$ wie in Fig. 8 approximiert. Dementsprechend wird der Parameterwert zum Zeitschritt $t_3$ aus den unmittelbar vorangehenden und folgenden Zeitschritten $t_2$ und $t_4$ zu $x'_3(t_3)$ approximiert, usw. Unverändert bleiben die Parameterwerte zu den geradzahligen Zeitschritten $t_0$, $t_2$ usw. Diese können ebenfalls approximiert werden, indem nun einer dieser Werte nicht basierend auf dem unmittelbar benachbarten Parameterwert bzw. dem unmittelbar vorhergehenden und unmittelbar nachfolgenden Parameterwert sondern aus einem Parameterwert zwei Zeitschritte vorher und einem Parameterwert zwei Zeitschritte nachher approximiert wird. So ist in Fig. 8a dargestellt, dass der Parameterwert zum Zeitschritt $t_2$ aus

dem Parameterwert zum Zeitschritt $t_0$ und $t_4$ zu $x''_1(t_2)$ approximiert wird. Gleichermaßen wird der Parameterwert zum Zeitschritt $t_6$ aus den Parameterwerten zu den Zeitschritten $t_4$ und $t_8$ approximiert, usw.

Nachfolgend ist lediglich nur noch jeder vierte Parameterwert nicht in einen Differenzwert umgewandelt worden. Diese können ebenfalls approximiert werden, indem die Anzahl der Zeitschritte zwischen dem zu approximierenden Parameterwert und den Parameterwerten, aus denen approximiert werden soll, auf 3 erhöht wird. So wird, wie es in Fig. 8a noch angedeutet ist, der Wert des Parameters $x_1$ zum Zeitschritt $t_4$ aus den Parameterwerten $x_1$ zum Zeitpunkt $t_0$ und $t_8$ zu $x'''_1(t_4)$ approximiert.

Aus Fig. 8a geht hervor, dass schließlich für einen Parameter die Parameterwerte fast aller Zeitschritte aus den Parameterwerten eines vorangehenden und eines vorausgehenden Zeitschritts approximiert werden können. Die zeitliche Approximation wird hierarchisch durchgeführt, indem zunächst jeder zweite Parameter zunächst aus den Parameterwerten des unmittelbar vorhergehenden und unmittelbar nachfolgenden Zeitschritts approximiert werden, welches in Fig. 8a als erste Hierarchieebenestufe 12 angedeutet ist, danach unter den nicht-approximierten jeder zweite auf der Basis der Parameterwerte zwei Zeitschritte vorher bzw. zwei Zeitschritte nachher approximiert wird, wobei diese Hierarchieebene in Fig. 8a mit 114 angedeutet ist, dann unter den immer noch nicht-approximierten Parameterwerten usw.

Die zeitliche Interpolation nach Fig. 8-8a wird für jeden Knoten durchgeführt. Ferner wird die zeitliche Approximation 102 für jeden Parameter, d.h. noch für y, z, $v_x$, $v_y$ und $v_z$ wiederholt (Schritt 116).

Bis auf wenige Zeitschritte enthält nach Schritt 116 folglich jeder Zeitschritt nur noch Differenzwerte zur zeitlichen Approximation. Auf diese Approximationsdifferenzen wird in einem Schritt 118 die räumliche Approximation nach Fig. 3 verwendet, indem dieselbe anstatt direkt auf die Parameterwerte auf die Approximationsdifferenzen zur Zeitlichen Approximation angewendet wird. Die räumliche Approximation wird für alle Zeitschritte durchgeführt (Schritt 120). Daraufhin wird in einem Schritt 122 wiederum die Bitdarstellungslänge reduziert, wie es auch bei Schritt 72 von Fig. 4 der Fall war.

Das Beispiel von Fig. 7-8a sah die Reihenfolge einer zeitlichen Approximation vor der räumlichen Approximation vor. Freilich ist es ferner möglich, die räumliche Approximation bis zu einer gewissen Hierarchiestufe vorzusehen und erst dann auf die verbleibenden Approximationswerte, d.h. die als Approximation dienenden Parameterwerte der Referenzknoten in den entsprechenden Supergruppen oder die Mittelwerte der entsprechenden Supergruppen, anschließend eine zeitliche Approximation anzuwenden. Zeitlich und räumliche Approximation können sich folglich in beliebiger Reihenfolge abwechseln. Eine bestimmte Kombination bzw. Reihenfolge zwischen zeitlicher und räumliche Approximation kann für bestimmte Simulationen die vorteilhafteste Komprimierungsrate ergeben, wobei es hierzu vor allem auf die Art des jeweiligen Parameters ankommt. Folglich ist es ferner möglich, verschiedene Abfolgen zeitlicher und räumlicher Approximation für die unterschiedlichen Parameter in einer Simulation zu verwenden. So ist beispielsweise die räumliche Approximation als erster Approximationsschritt für die Ortsparameter x, y und z weniger zu bevorzugen, da dort ja auf jeden Fall Approximationsdifferenzen entstehen. Vorteilhafter ist dort eine zeitliche Approximation, denn schließlich befindet sich der Ort eines Knotenpunkt des unregelmäßigen Gitters bei der Crash-Simulation beispielsweise sehr oft genau zwischen den beiden Orten zu einem Zeitschritt vorher und einem Zeitschritt nachher.

Eine weitere Variation zu dem Beispiel von Fig. 7-8a besteht beispielsweise darin, als zeitliche Approximation zunächst die Parameterwerte des vorhergehenden Zeitschritts als Approximation für die Werte des neuen Zeitschritts zu verwenden, und erst die Approximationsdifferenzen hiervon der räumlichen Approximation zu unterziehen. In spezifischer Weise für die Crash-Simulation könnte die einfache Übernahme der Parameterwerte des vorhergehenden Zeitschritts als Approximation für den interessierenden Zeitschritt dadurch variiert werden, dass als Approximation der Ortsparameter die Ortskoordinaten des vorangehenden Zeitschritts plus eine Konstante verwendet werden, die beispielsweise der Anfangsgeschwindigkeit des Crash-Simulationsobjektes kurz vor dem Aufprall multipliziert mit der Zeitdifferenz zwischen den Zeitschritten entspricht. Wird beispielsweise ein Crash mit Aufprallrichtung entlang der x-Koordinatenachse simuliert, könnten die x-Parameterwerte zum Zeitpunkt $t_1$ beispielsweise im ersten Approximationsschritt auf Approximationsdifferenzen x' abgebildet werden, für die $x'(\Delta t + t_0) = x(\Delta t + t_0) - \Delta x - x(t_0)$ gilt, wobei $\Delta x = v_x / \Delta t$, $v_x$ die Aufprallgeschwindigkeit in Richtung x, $\Delta t = t_1 - t_0$ und $t_0$ der Zeitpunkt des vorhergehenden Zeitschrittes ist.

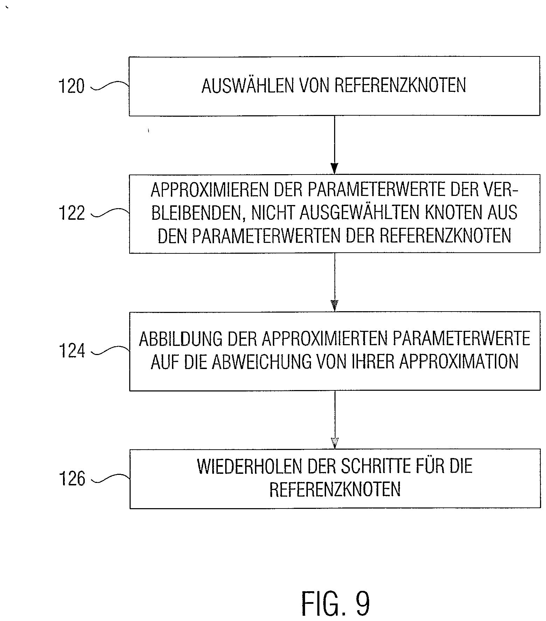

Ein weiteres Beispiel zur Komprimierung wird bezugnehmend auf Fig. 9 beschrieben. Im Unterschied zu den obigen Verfahren mit räumlicher Interpolation beginnt dieses Verfahren mit der Auswahl 120 von Referenzknoten unter den Gitterknoten. Die Auswahl erfolgt vorzugsweise derart, dass die Referenzknoten nicht zueinander benachbart sind, und vorzugsweise derart, dass jeder sonstige Knoten zu zumindest einem Referenzknoten benachbart ist. Diese Kriterien erfüllen beispielsweise die durch Umkreisung markierten Knoten 2, 6, 10 und 13 zusammen mit Knoten 17 in Fig. 5. Knoten 6 ist beispielsweise durch keine Verbindungslinie, d.h. keine Nachbarknotenpaar, direkt mit einem der anderen Referenzknoten 2, 10 oder 13 verbunden und umgekehrt ist jeder der anderen Knoten mit einem der Referenzknoten verbunden. In einem Schritt 122 werden die Parameterwerte der verbleibenden, nicht ausgewählten Knoten, d.h. in Fig. 5 die Knoten außer den Knoten 2, 6, 10, 13 und 17, dann durch eine geeignete Interpolation aus den Parameterwerten der Referenzknoten approximiert, wodurch sich für jeden dieser Knoten ein Approximationswert ergibt. Der Approximationswert für den Parameter eines Knotens wird beispielsweise zu dem Mittelwert der Parameterwerte der zu diesem knoten benachbarten Referenzknoten berechnet. Freilich kann auch eine Interpolation über die benachbarten Referenzknoten auf der Basis der Geometrieinformationen verwendet werden, um die Approximationswerte zu berechnen, wie z.B. die Summe der Parameterwerte der benachbarten Referenzknoten gewichtet mit dem Inversen ihres Abstandes geteilt durch die Summe der Gewichtungen. Danach erfolgt die Abbildung 124 der approximierten Parameterwerte auf die Abweichung von ihrer Approximation ähnlich den vorhergehenden Ausführungsbeispielen. Das Ergebnis ist die Abbildung der Nicht-Referenzknoten auf die Approximationsabweichungen, während die Referenzknotenparameterwerte im Kodierten Datenstrom unverändert übernommen werden.

Die Schritte 120-124 werden jedoch, ähnlich den vorhergehenden Ausführungsbeispielen iterativ noch mal für die Referenzknoten wiederholt 126, so dass sich für die Mehrheit der Referenzknoten Interpolationswerte bzw. Approximationsabweichungswerte ergeben, die in Verbindung mit den Parameterwerten weniger Superreferenzknoten der höheren Hierarchieebene die Parameterwerte derselben ermitteln lassen usw. Die Nachbarschaft der Referenzknoten zu den (Super-) Referenzknoten in der höheren Hierarchieebene besteht nicht mehr in einer unmittelbaren Nachbarschaft derselben in Bezug auf das ursprüngliche Gitter sondern in einer Nachbarschaft über eine oder mehrere Verbindungen, aber kann als unmittelbare Nachbarschaft eines nut noch aus den Referenzknoten bestehenden Übergitters angesehen werden. Im Endeffekt ergibt sich widere eine Hierarchische Struktur der komprimierten Daten mit nur wenigen großen unkomprimiert in den komprimierten Datenstrom übernommenen Parameterwerten, wobei freilich auch das vorliegende Ausführungsbeispiel mit den im vorhergehenden Hierarchieweise kombiniert werden kann.

Bei der vorhergehenden Beschreibung wurde übergangen, dass die Gruppeneinteilungen bzw. die Auswahl an Referenzknoten bei der räumlichen Approximation freilich auf Dekomprimiererseite nachvollziehbar sein müssen. Dies kann entweder dadurch erzielt werden , dass der Dekomprimierer den gleichen Einteilungsalgorithmus verwendet wie der Komprimierer, so dass er auf der Basis des in den komprimierten Simulationsdaten beispielsweise unkomprimiert oder komprimiert enthaltenen Bestimmungsblocks, insbesondere auf der Basis der darin enthaltenen Nachbarschaftsbeziehungen, auf dasselbe Gruppeneinteilungsergebnis kommt wie der Decodierer. Eine weitere Möglichkeit besteht freilich darin, dass die codierten Simulationsdaten ferner mit einem eigens vorgesehenen Gruppeneinteilungsblock versehen werden, wie z.B. im Schritt 54, der die Gruppenzugehörigkeit der einzelnen Knoten definiert, d.h. definiert, welcher Knoten zu welcher Gruppe gehört. Der Dekomprimierer kann dann aufgrund des interpolierten Werts bzw. des Approximationsdifferenzwertes und der in demselben Parametersatz enthaltenen Angabe über den Approximationswert auf den ursprünglichen Parameterwert jedes Knotens rückschließen.

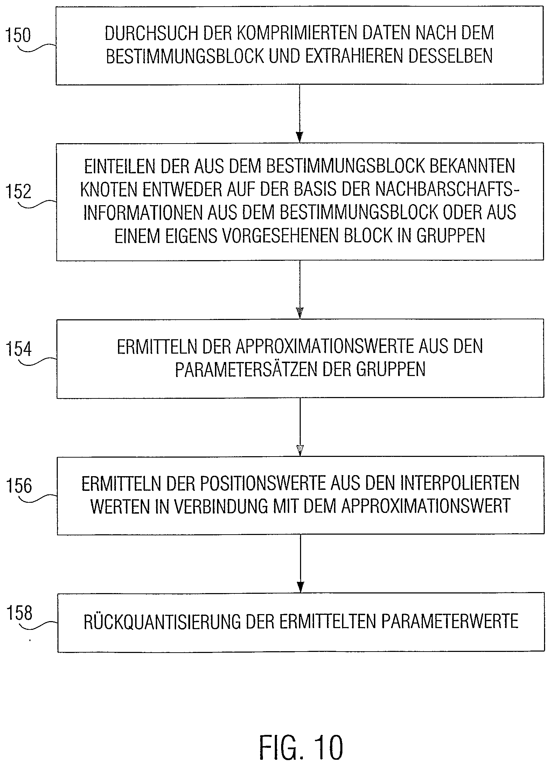

Fig. 10 zeigt ein Verfahren zum Dekomprimieren der nach dem Verfahren von Fig. 3 komprimierten Simulationsdaten, was durch den Dekomprimierer 14C durchgeführt wird. In einem Schritt 150 durchsucht der Dekomprimierer 14C zunächst die komprimierten Daten nach dem Bestimmungsblock und extrahiert denselben, wobei er denselben gegebenenfalls erst nach bestimmten herkömmlichen Dekomprimierungsalgorithmen dekomprimieren muss. In einem Schritt 152 teilt dann der Dekomprimierer die aus dem Bestimmungsblock bekannten Knoten entweder auf der Basis der Nachbarschaftsinformationen aus dem Bestimmungsblock genauso wie bei der Komprimierung in Schritt 54 in Gruppen ein, oder er nimmt die Einteilung nach einem hierfür eigens vorgesehenen Block mit zusätzlichen Informationen vor, die Angaben über die Gruppen, Supergruppen usw. macht.

In einem Schritt 154 ermittelt dann der Dekomprimierer die Angabe des Approximationswertes in dem Parametersatz jeder Gruppe und ermittelt aus ihr den Approximationswert für diese Gruppe. Daraufhin, in einem Schritt 156, ermittelt der Dekomprimierer die Positionswerte aus den Differenzwerten in Verbindung mit dem Approximationswert der jeweiligen Gruppe.

Es wird darauf hingewiesen, dass obiges Verfahren rekursiv ist, in dem Sinne, dass der Schritt 154 ja wiederum auf einen interpolierten Approximationswert stoßen kann, der es erforderlich macht, die Gruppen der nächsten Hierarchieebene wieder in Supergruppen einzuteilen (Schritt 152), und den Approximationswert für die entsprechende, die interessierende Gruppe enthaltende Supergruppe zu ermitteln (Schritt 154) und Letztgenannten für die Bestimmung des Approximationswerts für die interessierende Gruppe der ersten Hierarchieebene heranzuziehen (Schritt 156), wenn dieser nicht wiederum rekursiv aus usw.

Anschließend erfolgt lediglich eine mit dem Schritt 50 korrespondierende Rückquantisierung der ermittelten Parameterwerte in einem Schritt 158, aus welchem Paar von Schritten sich der einzige und je nach Quantisierung in Schritt 50 einstellbare Informationsverlust in den Simulationsdaten ergibt.

Obige Ausführungsbeispiele und Beispiele führen bei einer Simulationsumgebung, wie sie in Fig. 1 exemplarisch gezeigt ist, zu einer erheblichen Entlastung des Speichers 14b, der weniger Kapazität erfordert und damit kostengünstiger ist. Im Fall der in Fig. 14 gezeigten Simulation können mit obigen Kompressionsverfahren die Knotenpositionen beispielsweise im Mittel mit 3 Bit Genauigkeit anstatt 32 Bit Genauigkeit gespeichert werden, wenn dem Ingenieur eine Genauigkeit von 0,1 mm ausreicht.

Obige Ausführungsbeispiele und Beispiele ermöglichen folglich unter Nutzung von Interpolationsverfahren durch die räumliche Approximation auch für Simulationsergebnisse eine substantielle Reduktion des Volumens der aus Berechnungen auf unstrukturierten bzw. nicht-regulären Gittern gewonnen Simulationsdaten, ohne dass die Qualität der gespeicherten Ergebnisse wesentlich reduziert wird. Insbesondere wird dies bei denselben dadurch ermöglicht, dass der Wert der Lösung an den Gitterpunkten aus vorhandener Information interpoliert wird. Damit braucht nur noch die Differenz zwischen Approximation and Lösung gespeichert werden. Diese Differenz lässt sich jedoch mit Hilfe bekannter Verfahren wesentlich kompakter darstellen, als die ursprüngliche Lösung. Die obigen Kompressionsalgorithmen sahen dafür im wesentlichen folgende Varianten vor, bei denen aber jeweils die Differenz zwischen den quantifizierten Parameterwerten und der Approximation jeweils als Basis für den nächsten Teilschritt diente: Gemäß einer zeitlichen Fortschreibung konnte als Näherung für den neuen Zeitschritt die Werte vom alten Zeitschritt übernommen werden. Gemäß einer Interpolation in der Zeit wurden die Werte an jedem zweiten Zeitschritt aus den beiden benachbarten Zeitschritten linear interpoliert. Dieser Prozess wurde hierarchisch fortgesetzt. Gemäß der Interpolation im Raum werden mit Hilfe beispielsweise eines Greedy Algorithmus Nachbarelemente zusammengefasst und der Mittelwert der Werte über diese Nachbarelemente bestimmt. Dabei kann beispielsweise jeder Knoten einem Element fest zugeordnet sein. Für die interpolierten Werte wurde die Differenz zwischen Zielwert und interpoliertem Wert gespeichert. Wird bei der Dekomprimierung ein Wert an einem Gitterpunkt zur Interpolation weiter verwendet, so wird dieser Wert zunächst mit diesem Differenzwert korrigiert.

Danach erfolgte jeweils eine Codierung der Eintrage in der hierarchischen Basis, wobei pro Hierarchiestufe and Zeitschritt der niedrigste Wert global gespeichert wurde und pro Wert die Anzahl der Inkremente im Sinne der Quantifizierung gespeichert wurde. Der maximale Wert der Zahl der Inkremente ist klein, so dass dann wenige Bits für die Codierung ausreichen.

Obige Beschreibung ist ferner auch auf Simulationsdaten anwendbar, bei denen die Gitterpositionen, an denen die Parameterwerte definiert sind, Elemente und nicht Knoten sind.

Es wird darauf hingewiesen, dass es ferner möglich wäre in einem Parametersatz einen oder mehrere der Parameterwerte identisch auf sich selbst abzubilden, d.h. unkomprimiert zu lassen, und beispielsweise lediglich einen auf einen Differenzwert abzubilden und damit die Datenreduktion zu ermöglichen bzw. vorzubereiten, indem der Parametersatz dann verglichen zu der Bitdarstellung der ursprünglichen Parameterwerte zusammen mit reduzierter Bitlänge dargestellt werden kann.

Insbesondere wird darauf hingewiesen, dass abhängig von den Gegebenheiten das erfindungsgemäße Schema zur Datenkompression bzw. -dekompression auch in Software implementiert sein kann, wie es ja auch im vorhergehenden beschrieben worden ist. Die Implementation kann auf einem digitalen Speichermedium, insbesondere einer Diskette oder einer CD mit elektronisch auslesbaren Steuersignalen erfolgen, die so mit einem programmierbaren Computersystem zusammenwirken können, dass das entsprechende Verfahren ausgeführt wird. Allgemein besteht die Erfindung somit auch in einem Computerprogrammprodukt mit auf einem maschinenlesbaren Träger gespeicherten Programmcode zur Durchführung des erfindungsgemäßen Verfahrens, wenn das Computerprogrammprodukt auf einem Rechner abläuft. In anderen Worten ausgedrückt kann die Erfindung somit als ein Computerprogramm mit einem Programmcode zur Durchführung des Verfahrens realisiert werden, wenn das Computerprogramm auf einem Computer abläuft.

## Patentansprüche

1.  Computerimplementiertes Verfahren zum Komprimieren von Daten (28), wobei die Daten für einen Parameter für jede Gitterposition (56) von Gitterpositionen eines unregelmäßigen Gitters (58) einen Parameterwert umfassen sowie einen Bestimmungsblock (26), der Nachbarschaftsinformationen umfasst, die für jede Gitterposition (56) angeben, zu welcher oder welchen Gitterpositionen die jeweilige Gitterposition benachbart ist, mit folgenden Schritten:

    Einteilen (54) der Gitterpositionen (56) in Gruppen (60-66) von zueinander benachbarten Gitterpositionen auf der Basis der Nachbarschaftsinformationen, wobei jede Gitterposition (56) nur einer Gruppe zugeteilt wird ; für jede Gruppe

        Ermitteln (68) eines Approximationswertes aus zumindest dem Parameterwert einer Gitterposition unter den zueinander benachbarten Gitterpositionen; und
        Abbilden (70) der Parameterwerte der Gitterpositionen der Gruppe auf einen Parametersatz, bei dem zumindest der Parameterwert einer Gitterposition auf einen Differenzwert abgebildet ist, aus dem jeweils in Verbindung mit dem Approximationswert auf den jeweiligen Parameterwert rückgeschlossen werden kann, und der eine Angabe enthält, aus der der Approximationswert ermittelbar ist;

    gekennzeichnet durch die folgenden weiteren Schritten:
    Wiederholen der Schritte des Einteilens, Ermittelns und Abbildens für ein aus den Gruppen von Gitterpositionen gebildetes Übergitter und ihre Approximationswerte.

2. Computerimplementiertes Verfahren gemäß Anspruch 1, bei der der Schritt des Abbildens der Parameterwerte derart durchgeführt wird, dass der Approximationswert der Mittelwert der Parameterwerte aller Gitterpositionen der Gruppe und der Differenzwert die Differenz des Parameterwerts zum Mittelwert ist.

3. Computerimplementiertes Verfahren gemäß Anspruch 1, bei der der Schritt des Abbildens der Parameterwerte durchgeführt wird, dass der Approximationswert der Parameterwert einer Referenzgitterposition unter den Gitterpositionen der Gruppe ist, und der Differenzwert die Differenz des Positionswertes dieser Gitterposition zu dem Positionswert der Referenzgitterposition ist.

4. Computerimplementiertes Verfahren gemäß einem der vorhergehenden Ansprüche, bei dem der Parameter eine Ortskoordinate oder eine Geschwindigkeitskomponente in einer Koordinatenrichtung ist.

5. Computerimplementiertes Verfahren gemäß einem der Ansprüche 1 bis 4, bei dem die Daten die Daten einer Crash-Simulation sind.

6. Computerimplementiertes Verfahren gemäß einem der Ansprüche 1 bis 5, bei dem zumindest einer der Schritte des Abbildens derart durchgeführt wird, dass nach der Abbildung die Bitdarstellung der Daten eine kleinere Gesamtlänge aufweist.

7. Computerimplementiertes Verfahren gemäß einem der Ansprüche 1 bis 6, bei dem am Ende des Verfahrens eine Huffman-Codierung durchgeführt wird.

8. Vorrichtung zum Komprimieren von Daten (28), wobei die Daten für einen Parameter für jede Gitterposition (56) von Gitterpositionen eines unregelmäßigen Gitters (58) einen Parameterwert umfassen sowie einen Bestimmungsblock (26), der Nachbarschaftsinformationen umfasst, die für jede Gitterposition (56) angeben, zu welcher oder welchen Gitterpositionen die jeweilige Gitterposition benachbart ist, mit folgenden Merkmalen:

Eine erste Einrichtung, die ausgebildet ist, um die Gitterpositionen (56) in Gruppen (60-66) von zueinander benachbarten Gitterpositionen auf der Basis der Nachbarschaftsinformationen einzuteilen (54), wobei jede Gitterposition (56) nur einer Gruppe zugeteilt wird;
Eine zweite Einrichtung, die ausgebildet ist, um, für jede Gruppe,

einen Approximationswert aus zumindest dem Parameterwert einer Gitterposition unter den zueinander benachbarten Gitterpositionen zu ermitteln (68); und
die Parameterwerte der Gitterpositionen der Gruppe auf einen Parametersatz abzubilden (70), bei dem zumindest der Parameterwert einer Gitterposition auf einen Differenzwert abgebildet ist, aus dem jeweils in Verbindung mit dem Approximationswert auf den jeweiligen Parameterwert rückgeschlossen werden kann, und der eine Angabe enthält, aus der der Approximationswert ermittelbar ist;

**gekennzeichnet dadurch, dass**
die erste und die zweite Einrichtungen ausgebildet sind, um das Einteilen, Ermitteln und Abbilden für ein aus den Gruppen von Gitterpositionen gebildetes Übergitter und ihre Approximationswerte zu wiederholen.

9. Computerimplementiertes Verfahren zum Dekomprimieren von komprimierten Daten, wobei die dekomprimierten Daten für einen Parameter für jede Gitterposition (56) von Gitterpositionen eines unregelmäßigen Gitters (58) einen Parameterwert umfassen sowie einen Bestimmungsblock (26), der Nachbarschaftsinformationen umfasst, die für jede Gitterposition (56) angeben, zu welcher oder welchen Gitterpositionen die jeweilige Gitterposition benachbart ist, wobei die Gitterpositionen auf der Basis der Nachbarschaftsinformationen oder auf der Basis eines eigens vorgesehenen Blocks in den komprimierten Daten in Gruppen von zueinander benachbarten Gitterpositionen einteilbar sind, und wobei die komprimierten Daten für jede Gruppe einen Parametersatz, der für zumindest eine vorbestimmte Gitterposition einen Differenzwert, aus dem jeweils in Verbindung mit einem Approximationswert auf den Parameterwert der vorbestimmten Gitterposition rückgeschlossen werden kann, aufweist, und eine Angabe aufweisen, aus der der jeweilige Approximationswert ermittelbar ist, mit folgenden Schritten:

Einteilen der Gitterpositionen in Gruppen von zueinander benachbarten Gitterpositionen, wobei jede Gitterposition (56) nur einer Gruppe zugeteilt wird; und
für jede Gruppe,

Ermitteln des Approximationswertes aus der Angabe; und

Rückschließen auf den Parameterwert der vorbestimmten Gitterposition aus dem Differenzwert in Verbindung mit dem Approximationswert,

wobei der Schritt des Ermittelns das Wiederholen der Schritte des Einteilens, Ermittelns und Rückschließens für ein aus den Gruppen von Gitterpositionen gebildetes Übergitter und ihre Approximationswerte aufweist.

10. Vorrichtung zum Dekomprimieren von komprimierten Daten, wobei die dekomprimierten Daten für einen Parameter für jede Gitterposition (56) von Gitterpositionen eines unregelmäßigen Gitters (58) einen Parameterwert umfassen sowie einen Bestimmungsblock (26), der Nachbarschaftsinformationen umfasst, die für jede Gitterposition (56) angeben, zu welcher oder welchen Gitterpositionen die jeweilige Gitterposition benachbart ist, wobei die Gitterpositionen auf der Basis der Nachbarschaftsinformationen oder auf der Basis eines eigens vorgesehenen Blocks in den komprimierten Daten in Gruppen von zueinander benachbarten Gitterpositionen einteilbar sind, und wobei die komprimierten Daten für jede Gruppe einen Parametersatz, der für zumindest eine vorbestimmte Gitterposition einen Differenzwert, aus dem jeweils in Verbindung mit einem Approximationswert auf den Parameterwert der vorbestimmten Gitterposition rückgeschlossen werden kann, aufweist, und eine Angabe aufweisen, aus der der jeweilige Approximationswert ermittelbar ist, mit folgenden Merkmalen:

Einer ersten Einrichtung, die ausgebildet ist, um die Gitterpositionen in Gruppen von zueinander benachbarten Gitterpositionen einzuteilen, wobei jede Gitterposition (56) nur einer Gruppe zugeteilt wird; und

Einer zweiten Einrichtung, die ausgebildet ist, um, für jede Gruppe,

den Approximationswertes aus der Angabe zu ermitteln; und

auf den Parameterwert der vorbestimmten Gitterposition aus dem Differenzwert in Verbindung mit dem Approximationswert rückzuschließen,

wobei die erste und die zweite Einrichtungen ausgebildet sind, um das Einteilen, Ermitteln und Rückschließen für ein aus den Gruppen von Gitterpositionen gebildetes Übergitter und ihre Approximationswerte zu wiederholen.

11. Computer-Programm mit einem Programmcode zur Durchführung des Verfahrens nach einem der Ansprüche 1 bis 7 oder 9, wenn das Computer-Programm auf einem Computer abläuft.

## Claims

1. Computer-implemented method for compressing data (28), wherein the data includes for a parameter for each grid position (56) of grid positions of an irregular grid (58) a parameter value as well as a determination block (26) that includes neighborhood information indicating for each grid position (56) which grid position or grid positions the respective grid position is adjacent to, comprising:

classifying (54) the grid positions (56) into groups (60-66) of adjacent grid positions on the basis of the neighborhood information, each grid position (56) being assigned to one group only;

for each group:

determining (68) an approximation value at least from the parameter value of a grid position among the adjacent grid positions; and

mapping (70) the parameter values of the grid positions of the group onto a parameter set, wherein at least the parameter value of a grid position is mapped onto a differential value, from which, in conjunction with the approximation value, the respective parameter value may be inferred, and which contains an indication from which the approximation value may be determined;

**characterized by** the following steps:

repeating the steps of classifying, determining and mapping for a super-grid formed of the groups of grid positions, and for their approximation values.

2. Computer-implemented method according to claim 1, wherein the step of mapping the parameter values is performed such that the approximation value is the mean value of the parameter values of all grid positions of the group, and the differential value is the difference between the parameter value and the mean value.

3. Computer-implemented method according to claim 1, wherein the step of mapping the parameter values is performed such that the approximation value is the parameter value of a reference grid position among the grid positions of the group, and the differential value is the difference between the position value of this grid position and the position value of the reference grid position.

4. Computer-implemented method according to any one of the preceding claims, wherein the parameter is a location coordinate or a velocity component in a coordinate direction.

5. Computer-implemented method according to any one of claims 1 to 4, wherein the data is the data of a crash simulation.

6. Computer-implemented method according to any one of claims 1 to 5, wherein at least one of the steps of mapping is performed such that, after mapping, the bit representation of the data comprises a shorter overall length.

7. Computer-implemented method according to any one of claims 1 to 6, wherein Huffman coding is performed at the end of the method.

8. Apparatus for compressing data (28), wherein the data includes for a parameter for each grid position (56) of grid positions of an irregular grid (58) a parameter value as well as a determination block (26) that includes neighborhood information indicating for each grid position (56) which grid position or grid positions the respective grid position is adjacent to, comprising:

    a first means configured to classify (54) the grid positions (56) into groups (60-66) of adjacent grid positions on the basis of the neighborhood information, wherein each grid position (56) is assigned to one group only;
    a second means configured to, for each group:

        determine an approximation value at least from the parameter value of a grid position among the adjacent grid positions (68); and
        map the parameter values of the grid positions of the group onto a parameter set (70), wherein at least the parameter value of a grid position is mapped onto a differential value, from which, in conjunction with the approximation value, the respective parameter value may be inferred, and which contains an indication from which the approximation value may be determined;
        **characterized in that** the first and the second means are configured to repeat classifying, determining and mapping for a super-grid formed of the groups of grid positions, and for their approximation values.

9. Computer-implemented method for decompressing compressed data, wherein the decompressed data includes for a parameter for each grid position (56) of grid positions of an irregular grid (58) a parameter value as well as a determination block (26) that includes neighborhood information indicating for each grid position (56) which grid position or grid positions the respective grid position is adjacent to, wherein the grid positions may be classified on the basis of the neighborhood information or on the basis of a provided block in the compressed data into groups of adjacent grid positions, and wherein the compressed data comprises for each group a parameter set comprising for at least one predetermined grid position a differential value from which, in conjunction with an approximation value, the parameter value of the predetermined grid position may be inferred, and an indication from which the respective approximation value may be determined, comprising:

    classifying the grid positions into groups of adjacent grid positions, wherein each grid position (56) is assigned to one group only; and
    for each group:

        determining the approximation value from the indication; and
        inferring the parameter value of the predetermined grid position from the differential value in conjunction with the approximation value,

    wherein the step of determining comprises repeating the steps of classifying, determining and inferring for a super-grid formed of the groups of grid positions, and for their approximation values.

**10.** Apparatus for decompressing compressed data, wherein the decompressed data includes for a parameter for each grid position (56) of grid positions of an irregular grid (58) a parameter value as well as a determination block (26) that includes neighborhood information indicating for each grid position (56) which grid position or grid positions the respective grid position is adjacent to, wherein the grid positions may be classified on the basis of the neighborhood information or on the basis of a provided block in the compressed data into groups of adjacent grid positions, and wherein the compressed data comprises for each group a parameter set comprising for at least one predetermined grid position a differential value from which, in conjunction with an approximation value, the parameter value of the predetermined grid position may be inferred, and an indication from which the respective approximation value may be determined, comprising:

> a first means configured to classify the grid positions into groups of adjacent grid positions, wherein each grid position (56) is assigned to one group only; and
> a second means configured to, for each group:

>> determine the approximation value from the indication; and
>> infer the parameter value of the predetermined grid position from the differential value in conjunction with the approximation value,

> wherein the first and second means are configured to repeat the classifying, determining and inferring for a super-grid formed of the groups of grid positions, and for their approximation values.

**11.** Computer program having a program code for performing the method according to any one of claims 1 to 7 or 9 when the computer program runs on a computer.

## Revendications

**1.** Procédé de compression de données (28) mis en oeuvre par ordinateur, dans lequel les données pour un paramètre pour chaque position de grille (56) parmi les positions d'une grille irrégulière (58) comportent une valeur de paramètre ainsi qu'un bloc de détermination (26) qui comporte des informations de voisinage qui indiquent, pour chaque position de grille (56), la ou les positions auxquelles est adjacente la position de grille respective, aux étapes suivantes consistant à:

> diviser (54) les positions de grille (56) en groupes (60 à 66) de positions de grille adjacentes entre elles sur base des informations de voisinage, où chaque position de grille (56) n'est associée qu'à un seul groupe;
> pour chaque groupe

>> déterminer (68) une valeur d'approximation à partir d'au moins la valeur de paramètre d'une position de grille parmi les positions de grille adjacentes entre elles; et
>> mapper (70) les valeurs de paramètre des positions de grille du groupe sur un ensemble de paramètres dans lequel au moins la valeur de paramètre d'une position de grille est mappée sur une valeur de différence de laquelle peut être déduite la valeur de paramètre respective en rapport avec la valeur d'approximation, et qui contient une indication à partir de laquelle peut être déterminée la valeur d'approximation;

> **caractérisé par** les autres étapes suivantes consistant à:
> répéter les étapes de division, de détermination et de mappage pour une super-grille formée à partir des groupes de positions de la grille et de leurs valeurs d'approximation.

**2.** Procédé mis en oeuvre par ordinateur selon la revendication 1, dans lequel l'étape de mappage des valeurs de paramètre est effectuée de sorte que la valeur d'approximation soit la moyenne des valeurs de paramètre de toutes les positions de grille du groupe et que la valeur de différence soit la différence entre la valeur de paramètre et la valeur moyenne.

**3.** Procédé mis en oeuvre par ordinateur selon la revendication 1, dans lequel l'étape de mappage des valeurs de paramètre est effectuée de sorte que la valeur d'approximation soit la valeur de paramètre d'une position de grille de référence parmi les positions de grille du groupe, et que la valeur de différence soit la différence entre la valeur de cette position de grille et la valeur de la position de grille de référence.

4. Procédé mis en oeuvre par ordinateur selon l'une des revendications précédentes, dans lequel le paramètre est une coordonnée d'emplacement ou une composante de vitesse dans une direction de coordonnées.

5. Procédé mis en oeuvre par ordinateur selon l'une des revendications 1 à 4, dans lequel les données sont les données d'une simulation d'accident.

6. Procédé mis en oeuvre par ordinateur selon l'une des revendications 1 à 5, dans lequel au moins l'une des étapes de mappage est effectuée de sorte que, après le mappage, la représentation binaire des données présente une longueur totale plus petite.

7. Procédé mis en oeuvre par ordinateur selon l'une des revendications 1 à 6, dans lequel est effectué, à la fin du procédé, un codage de Huffman.

8. Dispositif de compression de données (28), dans lequel les données pour un paramètre pour chaque position de grille (56) parmi les positions d'une grille irrégulière (58) comportent une valeur de paramètre ainsi qu'un bloc de détermination (26) qui comporte des informations de voisinage qui indiquent, pour chaque position de grille (56), la ou les positions de grille auxquelles est adjacente la position de grille respective, aux caractéristiques suivantes:

   un premier moyen qui est conçu pour diviser les positions de grille (56) en groupes (60 à 66) de positions de grille adjacentes entre elles sur base des informations de voisinage (54), où chaque position de grille (56) est associée à un seul groupe;
   un deuxième moyen qui est conçu, pour chaque groupe,

      pour déterminer une valeur d'approximation à partir d'au moins la valeur de paramètre d'une position de grille parmi les positions de grille adjacentes entre elles (68); et
      pour mapper les valeurs de paramètre des positions de grille du groupe sur un ensemble de paramètres (70), où au moins la valeur de paramètre d'une position de grille est mappée sur une valeur de différence de laquelle peut être déduite la valeur de paramètre respective en rapport avec la valeur d'approximation, et qui contient une indication à partir de laquelle peut être déterminée la valeur d'approximation;

   **caractérisé par le fait que**
   les premier et deuxième moyens sont conçus pour répéter la division, la détermination et le mappage pour une super-grille formée à partir des groupes de positions de grille et de leurs valeurs d'approximation.

9. Procédé mis en oeuvre par ordinateur pour décomprimer des données comprimées, dans lequel les données décomprimées pour un paramètre pour chaque position de grille (56) parmi les positions d'une grille irrégulière (58) comportent une valeur de paramètre ainsi qu'un bloc de détermination (26) qui comporte des informations de voisinage qui indiquent, pour chaque position de grille (56), la ou les positions de grille auxquelles est adjacente la position de grille respective, dans lequel les positions de grille peuvent être divisées, sur base des informations de voisinage ou sur base d'un bloc prévu propre dans les données comprimées, en groupes de positions de grille adjacentes entre elles, et dans lequel les données comprimées présentent, pour chaque groupe, un ensemble de paramètres qui présente, pour au moins une position de grille prédéterminée, une valeur de différence à partir de laquelle peut être déduite chaque fois, en rapport avec une valeur d'approximation, la valeur de paramètre de la position de grille prédéterminée, et une indication à partir de laquelle peut être déterminée la valeur d'approximation respective, aux étapes suivantes consistant à:

   diviser les positions de grille en groupes de positions de grille adjacentes entre elles, où chaque position de grille (56) est associée à un seul groupe; et
   pour chaque groupe,

      déterminer la valeur d'approximation à partir de l'indication; et
      déduire la valeur de paramètre de la position de grille prédéterminée à partir de la valeur de différence en rapport avec la valeur d'approximation,

   dans lequel l'étape de détermination comporte le fait de répéter les étapes de division, de détermination et de déduction pour une super-grille formée à partir des groupes de positions de grille et de leurs valeurs d'approximation.

**10.** Dispositif pour décomprimer des données comprimées, dans lequel les données décomprimées pour un paramètre pour chaque position de grille (56) parmi les positions d'une grille irrégulière (58) comportent une valeur de paramètre ainsi qu'un bloc de détermination (26) qui comporte des informations de voisinage qui indiquent, pour chaque position de grille (56), la ou les positions de grille auxquelles est adjacente la position de grille respective, où les positions de grille peuvent être divisées, sur base des informations de voisinage ou sur base d'un bloc prévu propre dans les données comprimées, en groupes de positions de grille adjacentes entre elles, et où les données comprimées présentent, pour chaque groupe, un ensemble de paramètres qui présente, pour au moins une position de grille prédéterminée, une valeur de différence à partir de laquelle peut être déduite chaque fois, en rapport avec une valeur d'approximation, la valeur de paramètre de la position de grille prédéterminée, et une indication à partir de laquelle peut être déterminée la valeur d'approximation respective, aux caractéristiques suivantes:

un premier moyen qui est conçu pour diviser les positions de grille en groupes de positions de grille adjacentes, où chaque position de grille (56) est associée à un seul groupe; et
un deuxième moyen qui est conçu, pour chaque groupe,

pour déterminer la valeur d'approximation à partir de l'indication; et
pour déduire la valeur de paramètre de la position de grille prédéterminée de la valeur de différence en rapport avec la valeur d'approximation,

dans lequel les premier et deuxième moyens sont conçus pour répéter la division, la détection et la déduction pour une super-grille formée à partir des groupes de positions de grille et de leurs valeurs d'approximation.

**11.** Programme d'ordinateur avec un code de programme pour la mise en oeuvre du procédé selon l'une des revendications 1 à 7 ou 9, lorsque le programme d'ordinateur est exécuté sur un ordinateur.

FIG. 13

FIG. 1

FIG. 2

```
┌──────────────────────────────────────────────┐
│      QUANTISIERUNG DER PARAMETERWERTE         │──── 50
└──────────────────────────────────────────────┘
                       │
                       ▼
┌──────────────────────────────────────────────┐
│  RÄUMLICHE APPROXIMATION DER PARAMETER-        │
│  WERTE ZU EINEM ZEITSCHRITT UND ABBILDEN       │──── 52
│  DESSELBEN AUF DIE DIFFERENZ ZWISCHEN          │
│  APPROXIMATION UND TATSÄCHLICHEM WERT          │
└──────────────────────────────────────────────┘
```

NOCH ZEITSCHRITTE ÜBRIG  80

JA

NEIN

REDUZIEREN DER BITDARSTELLUNG ── 82

## FIG. 3

GRUPPIEREN DER KNOTEN — 54

AUSWÄHLEN EINES REFERENZKNOTENS IN JEDER GRUPPE — 68

NEHMEN DES PARAMETERWERTS DES REFERENZKNOTENS ALS APPROXIMATION FÜR DIE RESTLICHEN KNOTEN IN DER GRUPPE UND ABBILDEN DER PARAMETERWERTE DER LETZTGENANNTEN AUF DIE DIFFERENZ ZWISCHEN APPROXIMATION UND TATSÄCHLICHEM WERT — 70

WIEDERHOLEN DER SCHRITTE FÜR DIE REFERENZKNOTEN — 72

FIG. 4

FIG. 12

912

FIG. 5

60

74

58

62

56

64

66

FIG. 6

FIG. 7

FIG. 8

FIG. 8a

120 — AUSWÄHLEN VON REFERENZKNOTEN

122 — APPROXIMIEREN DER PARAMETERWERTE DER VER-BLEIBENDEN, NICHT AUSGEWÄHLTEN KNOTEN AUS DEN PARAMETERWERTEN DER REFERENZKNOTEN

124 — ABBILDUNG DER APPROXIMIERTEN PARAMETERWERTE AUF DIE ABWEICHUNG VON IHRER APPROXIMATION

126 — WIEDERHOLEN DER SCHRITTE FÜR DIE REFERENZKNOTEN

FIG. 9

150 — DURCHSUCH DER KOMPRIMIERTEN DATEN NACH DEM BESTIMMUNGSBLOCK UND EXTRAHIEREN DESSELBEN

152 — EINTEILEN DER AUS DEM BESTIMMUNGSBLOCK BEKANNTEN KNOTEN ENTWEDER AUF DER BASIS DER NACHBARSCHAFTS-INFORMATIONEN AUS DEM BESTIMMUNGSBLOCK ODER AUS EINEM EIGENS VORGESEHENEN BLOCK IN GRUPPEN

154 — ERMITTELN DER APPROXIMATIONSWERTE AUS DEN PARAMETERSÄTZEN DER GRUPPEN

156 — ERMITTELN DER POSITIONSWERTE AUS DEN INTERPOLIERTEN WERTEN IN VERBINDUNG MIT DEM APPROXIMATIONSWERT

158 — RÜCKQUANTISIERUNG DER ERMITTELTEN PARAMETERWERTE

FIG. 10

FIG. 11

FIG. 14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **C.E. STEFFEN.** Weather Data Compression. Proceedings of the 19th International Conference on Interactive Information and Processing Systems (ILPS) for Meteorology. *Oceonography and Hydrology,* Februar 2003
- **N. WANG.** Experiment of a waveletbased data compression technique with precision control. Proceedings of the 19th International Conference on Interactive Information and Processing Systems (ILPS) for Meteorology. *Oceonography and Hydrology,* Februar 2003
- Compression of Weather Forecast Data. In Proceedings of the 12th International Conference on Interactive Information and Processing Systems (IIPS) for Meteorology. **D. SAUPE.** Oceonography und Hydrology. American Meteorological Society, Januar 1996
- **J. H. AHN et al.** Motion-compensated compression of 3D animation models. *ELECTRONICS LETTERS,* 22. November 2001, vol. 37 (24), 1445-1446